# EUROPEAN PATENT APPLICATION

(11) **EP 4 322 729 A2**
(43) Date of publication of application: **14.02.2024**
(21) Application number: 23189707.5
(22) Date of filing: 04.08.2023
(51) Int. Cl.: H10K 59/38, H10K 59/80

(54) **DISPLAY DEVICE**

(30) Priority: 08.08.2022 KR 20220098293
(71) Applicant: Samsung Display Co., Ltd., Yongin-si, Gyeonggi-do 17113 (KR)
(72) Inventor: LEE, Ju Won, Giheung-gu, Yongin-si, Gyeonggi-do (KR); Kim, Ran, Giheung-gu, Yongin-si, Gyenggi-do (KR); Jeong, Soo Im, Giheung-gu, Yongin-si, Gyeonggi-do (KR); CHOI, Soon Mi, Giheung-gu, Yongin-si, Gyeonggi-do (KR)
(74) Representative: Dr. Weitzel & Partner

(57) **Abstract**

A display device includes a substrate, a low refractive index layer disposed on the substrate, a first capping layer disposed on the low refractive index layer and directly contacting an upper surface of the low refractive index layer, a second capping layer disposed on the first capping layer, and a wavelength conversion layer disposed on the second capping layer and having a refractive index higher than a refractive index of the low refractive index layer, wherein a nitrogen atomic ratio of the first capping layer is different from a nitrogen atomic ratio of the second capping layer.

## Description

### BACKGROUND

### 1. Field

The disclosure relates to a display device and a method of manufacturing the same.

### 2. Description of the Related Art

Display devices are becoming increasingly important with a development of multimedia. Accordingly, various display devices such as liquid crystal display devices ("LCDs") and organic light-emitting diode display devices ("OLEDs") are being developed.

Of the display devices, a self-light-emitting display device includes a self-light-emitting element such as an organic light-emitting diode. The self-light-emitting element may include two electrodes facing each other and a light-emitting layer interposed between the two electrodes.

When the self-light-emitting element is an organic light-emitting diode, electrons and holes respectively provided from the two electrodes may be recombined in the light-emitting layer to generate excitons. As the generated excitons change from an excited state to a ground state, light may be emitted.

A display device may include a color conversion element for realizing a color by receiving light from an organic light-emitting diode. The color conversion element may receive blue light from the organic light-emitting diode and emit light of blue, green and red, for example, so that images having various colors may be viewed. The color conversion element may be disposed in the form of a separate substrate in the display device or may be directly integrated with elements in the display device.

With the above display devices problems may arise regarding the capping layer quality as well as the panel reliability.

### SUMMARY

It is the objective of the invention to provide a display device having improved capping layer quality and improved panel reliability.

However, features of the disclosure are not restricted to the one set forth herein. The above and other features of the disclosure will become more apparent to one of ordinary skill in the art to which the disclosure pertains by referencing the detailed description of the disclosure given below.

In an embodiment of the disclosure, a display device includes a substrate, a low refractive index layer disposed on the substrate, a first capping layer disposed on the low refractive index layer and directly contacting an upper surface of the low refractive index layer, a second capping layer disposed on the first capping layer, and a wavelength conversion layer disposed on the second capping layer and having a refractive index higher than a refractive index of the low refractive index layer, wherein a nitrogen atomic ratio of the first capping layer is different from a nitrogen atomic ratio of the second capping layer.

In an embodiment, a first surface of the second capping layer directly contacts a second surface of the first capping layer, and an oxygen atomic ratio of the second capping layer is different from an oxygen atomic ratio of the first capping layer.

In an embodiment, the wavelength conversion layer comprises a bank layer defining a plurality of openings, and the bank layer comprises an organic insulating material and directly contacts a second surface facing the first surface of the second capping layer.

In an embodiment, the first capping layer and the second capping layer comprise silicon oxynitride having different element ratios.

In an embodiment, the nitrogen atomic ratio of the first capping layer is 10% to 35%, and the nitrogen atomic ratio of the second capping layer is 0.2% to 10%.

In an embodiment, the first capping layer comprises a plurality of pinholes extending from a first surface directly contacting the upper surface of the low refractive index layer toward the second surface facing the first surface, and the plurality of pinholes does not penetrate, that is fully penetrate, the first capping layer. In other words, the pinholes are blind holes. Preferably, the pinholes extend to maximum the half or less than the half of the thickness of the first capping layer.

In an embodiment, a length of each of the plurality of pinholes is about 50 nanometers (nm) to about 100 nm.

In an embodiment, the low refractive index layer comprises a resin and a plurality of inorganic particles dispersed in the resin, and the upper surface of the low refractive index layer comprises steps due to the plurality of inorganic particles.

In an embodiment, pinholes of the plurality of pinholes are adjacent to the steps.

In an embodiment, the plurality of inorganic particles comprises one or more of silica, magnesium fluoride, and iron oxide.

In an embodiment, each of the plurality of inorganic particles has a hollow.

In an embodiment of the disclosure, a display device includes a substrate, a bank layer disposed on the substrate and defining a plurality of openings, a wavelength conversion material layer disposed in the plurality of openings of the bank layer, a first capping layer disposed on the bank layer and the wavelength conversion material layer, and a second capping layer disposed on the first capping layer, wherein a first surface of the first capping layer directly contacts an upper surface of the wavelength conversion material layer and an upper surface of the bank layer, and a nitrogen atomic ratio of the first capping layer is different from a nitrogen atomic ratio of the second capping layer.

In an embodiment, a first surface of the second capping layer directly contacts a second surface of the first capping layer, and an oxygen atomic ratio of the second capping layer is different from an oxygen atomic ratio of the first capping layer.

In an embodiment, the first capping layer and the second capping layer comprise silicon oxynitride having different element ratios.

In an embodiment, the first capping layer comprises a plurality of pinholes extending from the first surface directly contacting the upper surface of the wavelength conversion material layer and the upper surface of the bank layer toward the second surface facing the first surface, the upper surface of the bank layer and the upper surface of the wavelength conversion material layer form a step, and pinholes of the plurality of pinholes are adjacent to the step.

In an embodiment of the disclosure, a display device includes a first substrate, a second substrate facing the first substrate, a light-emitting element disposed between the first substrate and the second substrate and emitting light, a wavelength conversion layer disposed between the light-emitting element and the second substrate, a low refractive index layer disposed between the wavelength conversion layer and the second substrate, comprising a resin and a plurality of inorganic particles dispersed in the resin, and having a refractive index lower than a refractive index of the wavelength conversion layer, a first capping layer disposed between the low refractive index layer and the wavelength conversion layer, and a second capping layer disposed between the first capping layer and the wavelength conversion layer, wherein an upper surface of the low refractive index layer comprises steps due to the plurality of inorganic particles, a first surface of the first capping layer directly contacts the upper surface of the low refractive index layer, a first surface of the second capping layer directly contacts a second surface facing the first surface of the first capping layer, and a nitrogen atomic ratio of the first capping layer is different from a nitrogen atomic ratio of the second capping layer.

In an embodiment, the wavelength conversion layer comprises a bank layer defining a plurality of openings, and the bank layer comprises an organic insulating material and directly contacts a second surface facing the first surface of the second capping layer.

In an embodiment, the first capping layer and the second capping layer comprise silicon oxynitride having different element ratios.

In an embodiment, an oxygen atomic ratio of the second capping layer is greater than an oxygen atomic ratio of the first capping layer.

In an embodiment, the nitrogen atomic ratio of the first capping layer is 10% to 35%, and the nitrogen atomic ratio of the second capping layer is 0.2% to 10%.

### BRIEF DESCRIPTION OF THE DRAWINGS

These and/or other features will become apparent and more readily appreciated from the following description of the embodiments, taken in conjunction with the accompanying drawings in which:
FIG. 1 is a perspective view of an embodiment of a display device;
FIG. 2 is a schematic cross-sectional view taken along line X1-X1'of FIG. 1;
FIG. 3 is a plan view of an embodiment of the display device;
FIG. 4 is an enlarged plan view of area A1 of FIG. 3, more specifically, a schematic plan view of a light-emitting unit included in the display device of FIG. 3;
FIG. 5 is an enlarged plan view of area A1 of FIG. 3, more specifically, a schematic plan view of a light-transmitting unit included in the display device of FIG. 3;
FIG. 6 is a schematic cross-sectional view taken along line X2-X2' of FIGS. 4 and 5;
FIG. 7 is an enlarged plan view of area A2 of FIG. 6;
FIG. 8 is a plan view illustrating an embodiment of the schematic arrangement of a first color filter of a color filter member included in the light-transmitting unit of the display device;
FIG. 9 is a plan view illustrating an embodiment of the schematic arrangement of a second color filter of the color filter member included in the light-transmitting unit of the display device;
FIG. 10 is a plan view illustrating an embodiment of the schematic arrangement of a third color filter of the color filter member included in the light-transmitting unit of the display device;
FIG. 11 is an enlarged view of area A3 of FIG. 6;
FIG. 12 is a view for comparing pinholes defined in inorganic layers having different nitrogen contents;
FIG. 13 is a transmission electron microscopy ("TEM") photograph of an embodiment of a second capping layer;
FIGS. 14 through 18 are views for explaining an embodiment of a process of manufacturing the second capping layer of the display device;
FIG. 19 is a schematic cross-sectional view of an embodiment of a pixel structure of a display device;
FIG. 20 is an enlarged view of area A5 of FIG. 19; and
FIGS. 21 through 23 are views for explaining a process of manufacturing a third capping layer of the display device in the embodiment of FIG. 19.

### DETAILED DESCRIPTION

Hereinafter, illustrative embodiments will be described with reference to the accompanying drawings.

It will be understood that, although the terms "first," "second," "third" etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, "a first element," "component," "region," "layer" or "section" discussed below could be termed a second element, component, region, layer or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "Or" means "and/or." As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The exemplary term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The exemplary terms "below" or "beneath" can, therefore, encompass both an orientation of above and below.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). The term such as "about" can mean within one or more standard deviations, or within ± 30%, 20%, 10%, 5% of the stated value, for example.

Unless otherwise defined, all terms (including technical and scientific terms) used herein have the same meaning as commonly understood by one of ordinary skill in the art to which this disclosure belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

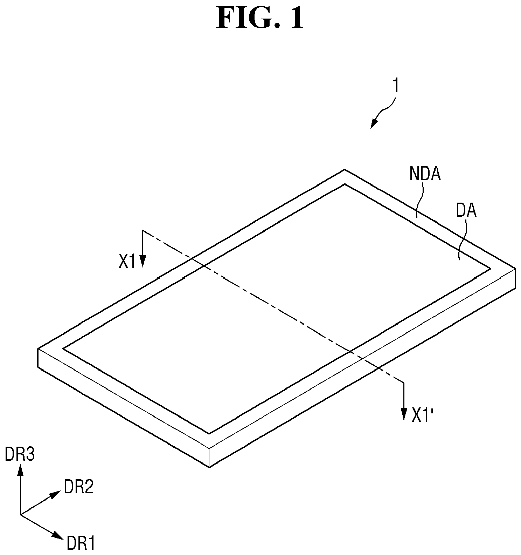

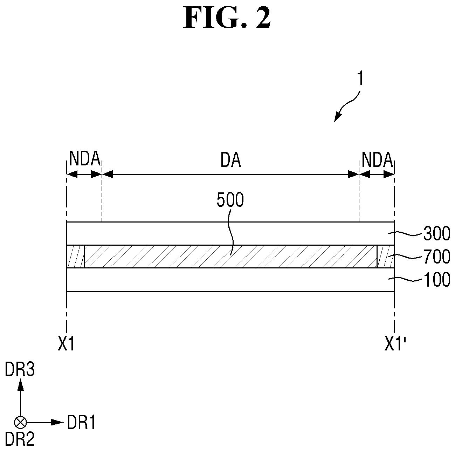

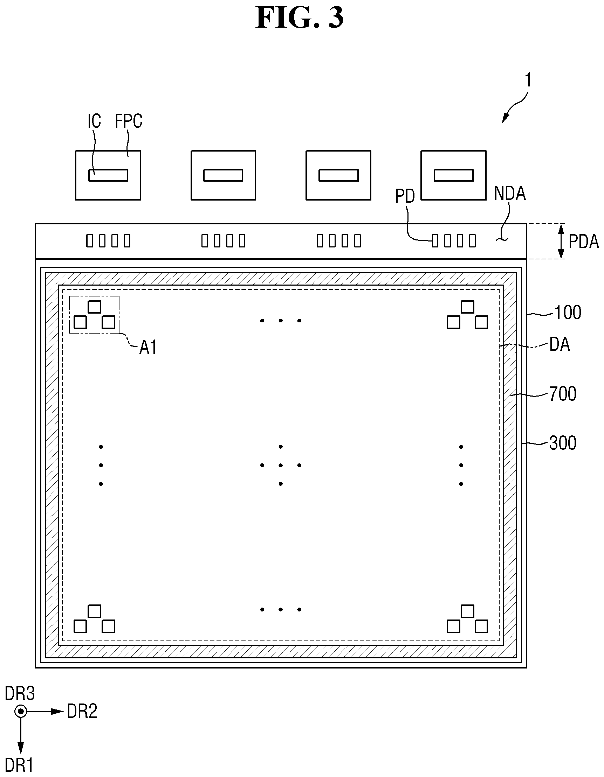

FIG. 1 is a perspective view of an embodiment of a display device 1. FIG. 2 is a schematic cross-sectional view taken along line X1-X1 'of FIG. 1. FIG. 3 is a plan view of an embodiment of the display device 1.

Referring to FIGS. 1 and 2, the display device 1 in the embodiment may be applied to portable electronic devices such as mobile phones, smartphones, tablet personal computers ("PCs"), mobile communication terminals, electronic notebooks, electronic books, portable multimedia players ("PMPs"), navigation devices, and ultra-mobile PCs ("UMPCs"). In an alternative embodiment, the display device 1 in the embodiment may be applied as a display unit of a television, a laptop computer, a monitor, a billboard, or an Internet of things ("IoT") device. However, these are presented only as examples, and the display device 1 in the embodiment may also be employed in other electronic devices without departing from the spirit of the disclosure.

In FIG. 1, a first direction DR1, a second direction DR2, and a third direction DR3 are defined. The first direction DR1 and the second direction DR2 may be perpendicular to each other, the first direction DR1 and the third direction DR3 may be perpendicular to each other, and the second direction DR2 and the third direction DR3 may be perpendicular to each other. It may be understood that the first direction DR1 refers to a horizontal direction in the drawing, the second direction DR2 refers to a vertical direction in the drawing, and the third direction DR3 refers to an up-down direction in the drawing, that is, a thickness direction. In the following specification, unless otherwise specified, a "direction" may refer to both directions extending to opposite sides along the direction. In addition, when it is desired to distinguish both "directions" extending to opposite sides, a first side is also referred to as a "first side in the direction," and a second side is also referred to as a "second side in the direction." Based on FIG. 1, a direction in which an arrow is directed is also referred to as the first side, and a direction opposite to the direction is also referred to as the second side.

Hereinafter, for ease of description, in referring to surfaces of the display device 1 or each member constituting the display device 1, one surface facing the first side in a direction in which an image is displayed, that is, in the third direction DR3 is also referred to as a top surface, and a surface opposite the one surface is also referred to as a bottom surface. However, the disclosure is not limited thereto, and the one surface and the other surface of each member may also be also referred to as a front surface and a rear surface or as a first surface and a second surface, respectively. In addition, in describing relative positions of the members of the display device 1, the first side in the third direction DR3 may be also referred to as an upper side, and the second side in the third direction DR3 may be also referred to as a lower side.

The display device 1 has a three-dimensional ("3D") shape. In an embodiment, the display device 1 may have a quadrangular (e.g., rectangular) parallelepiped shape or a 3D shape similar to the quadrangular (e.g., rectangular) parallelepiped shape, for example. In some embodiments, the display device 1 in the embodiment may have a planar shape similar to a quadrilateral. In other words, the display device 1 in the embodiment may have a planar shape similar to a quadrilateral having short sides in the first direction DR1 and long sides in the second direction DR2 as illustrated in FIG. 1. However, the disclosure is not limited thereto. In an embodiment, in the planar shape of the display device 1 in the embodiment, each corner where a long side extending in the first direction DR1 meets a short side extending in the second direction DR2 may be rounded with a predetermined curvature or may be right-angled, for example. The planar shape of the display device 1 is not limited to a quadrilateral shape but may also be similar to another polygonal shape, a circular shape, or an oval shape.

The display device 1 may include a display area DA in which a screen is displayed and a non-display area NDA in which a screen is not displayed. In some embodiments, the non-display area NDA may surround edges of the display area DA, but the disclosure is not limited thereto. An image displayed in the display area DA may be viewed by a user from the first side in the third direction DR3 based on FIG. 1.

As illustrated in FIG. 2, the display device 1 includes a light-emitting unit 100 and a light-transmitting unit 300 facing the light-emitting unit 100 and may further include a sealing member 700 bonding the light-emitting unit 100 and the light-transmitting unit 300 together and a filler 500 filling a space between the light-emitting unit 100 and the light-transmitting unit 300.

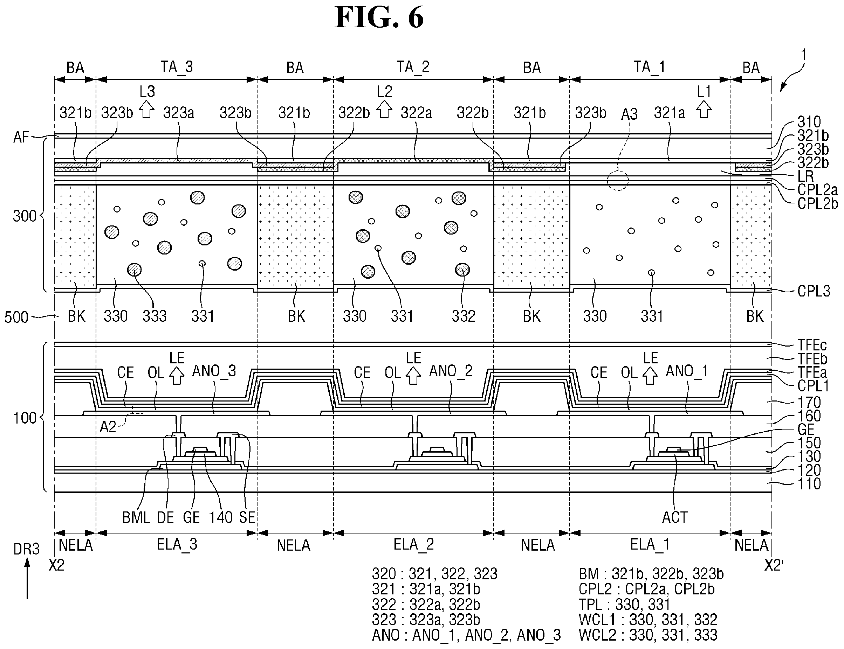

The light-emitting unit 100 includes elements and circuits for displaying an image, e.g., a pixel circuit such as switching elements, a pixel defining layer 170 (refer to FIG. 6) defining light-emitting areas and a non-light-emitting area to be described later in the display area DA, and self-light-emitting elements. In an embodiment, the self-light-emitting elements may include at least one of an organic light-emitting diode, a quantum dot light-emitting diode, an inorganic material-based micro light-emitting diode (e.g., micro LED), and an inorganic material-based nano light-emitting diode (e.g., nano LED). For ease of description, a case where the self-light-emitting elements are organic light-emitting diodes will be described below as one of embodiments.

The light-transmitting unit 300 may be disposed on the light-emitting unit 100 and may face the light-emitting unit 100. In some embodiments, the light-transmitting unit 300 may include a color conversion pattern for converting the color of incident light emitted from the light-emitting unit 100 and irradiated to the light-transmitting unit 300. In some embodiments, the light-transmitting unit 300 may include at least one of a color filter member 320 (refer to FIG. 6) and a light-transmitting member, which will be described later, as the color conversion pattern. In some embodiments, the light-transmitting unit 300 may include both the color filter member 320 and the light-transmitting member. The light-transmitting member may include wavelength conversion shifters and/or light scatterers as will be described later. The light-transmitting unit 300 may be also referred to as a color conversion element in the claims.

The sealing member 700 may be disposed between the light-emitting unit 100 and the light-transmitting unit 300 in the non-display area NDA. The sealing member 700 may be disposed along edges of the light-emitting unit 100 and the light-transmitting unit 300 in the non-display area NDA to surround the display area DA in a plan view. The light-emitting unit 100 and the light-transmitting unit 300 may be bonded to each other by the sealing member 700.

In some embodiments, the sealing member 700 may include or consist of an organic material. In an embodiment, the sealing member 700 may include or consist of, but not limited to, epoxy resin. In some embodiments, the sealing member 700 may be applied in the form of a frit including glass or the like.

The filler 500 may be disposed in the space between the light-emitting unit 100 and the light-transmitting unit 300 surrounded by the sealing member 700. The filler 500 may fill the space between the light-emitting unit 100 and the light-transmitting unit 300.

In some embodiments, the filler 500 may include or consist of a material that may transmit light. In some embodiments, the filler 500 may include or consist of an organic material. In an embodiment, the filler 500 may include or consist of a silicon-based organic material, an epoxy-based organic material, or a combination of a silicon-based organic material and an epoxy-based organic material.

Referring to FIG. 3, the display device 1 may further include flexible circuit boards FPC and driving chips IC.

The non-display area NDA of the display device 1 may include a pad area PDA, and a plurality of connection pads PD may be disposed in the pad area PDA. The pad area PDA may be defined on the light-emitting unit 100. Accordingly, the connection pads PD may be disposed on the light-emitting unit 100.

The flexible circuit boards FPC may be connected to the connection pads PD. The flexible circuit boards FPC may electrically connect the light-emitting unit 100 to a circuit board that provides signals and power for driving the display device 1.

The driving chips IC may be electrically connected to the circuit board to receive data and signals. In some embodiments, the driving chips IC may be data driving chips IC and may receive a data control signal and image data from the circuit board and generate and output data voltages corresponding to the image data.

In some embodiments, the driving chips IC may be disposed (e.g., mounted) on the flexible circuit boards FPC. In an embodiment, the driving chips IC may be disposed (e.g., mounted) on the flexible circuit boards FPC in the form of chips on films ("COF"), for example.

The data voltages provided from the driving chips IC, the power provided from the circuit board, etc., may be transmitted to pixel circuits of the light-emitting unit 100 via the flexible circuit boards FPC and the connection pads PD as will be described later.

A plurality of light-emitting areas defined in the light-emitting unit 100 of the display device 1 and a plurality of light-transmitting areas defined in the light-transmitting unit 300 will now be described in more detail.

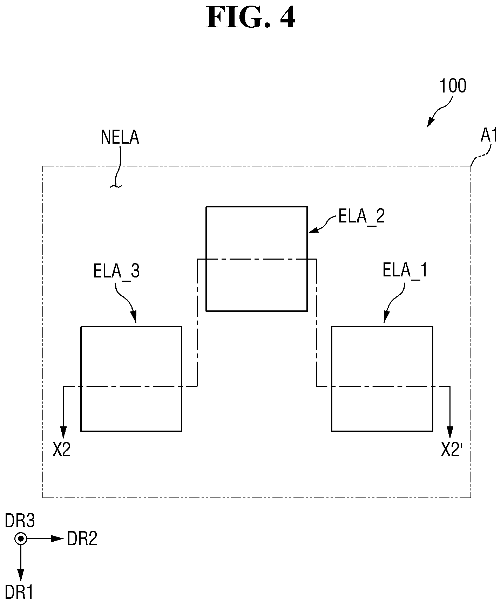

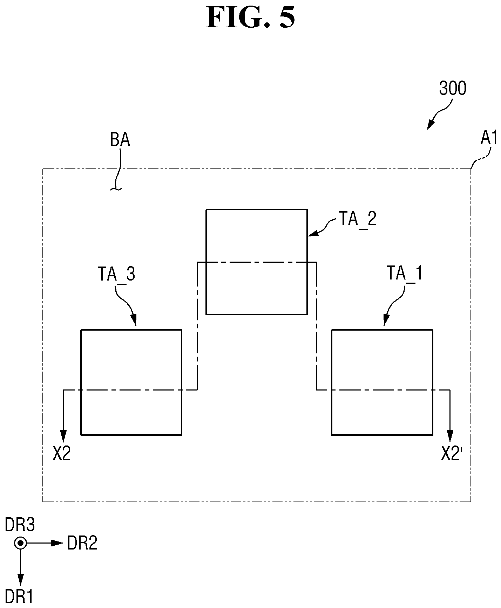

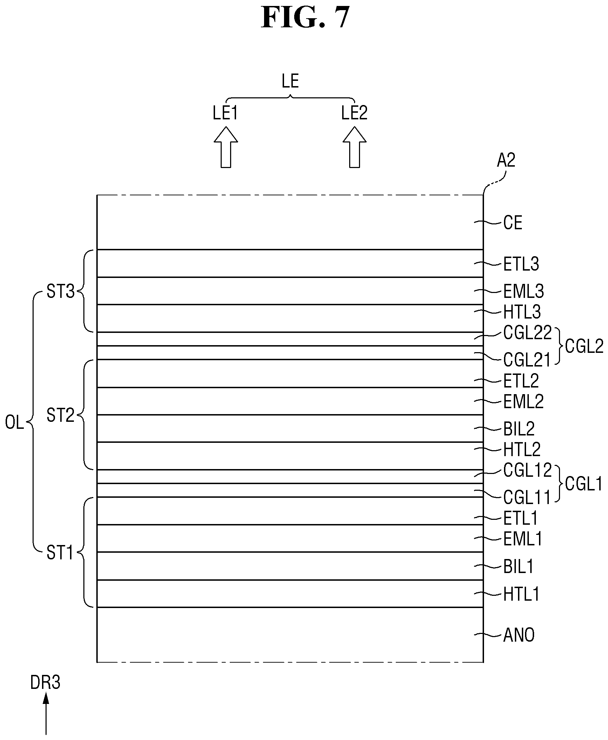

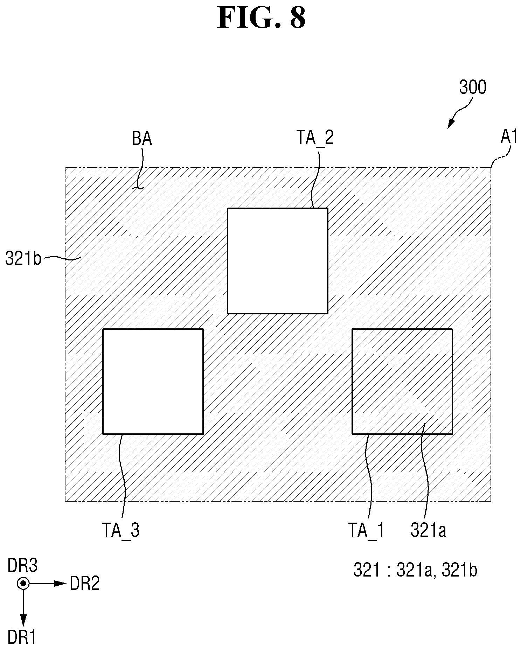

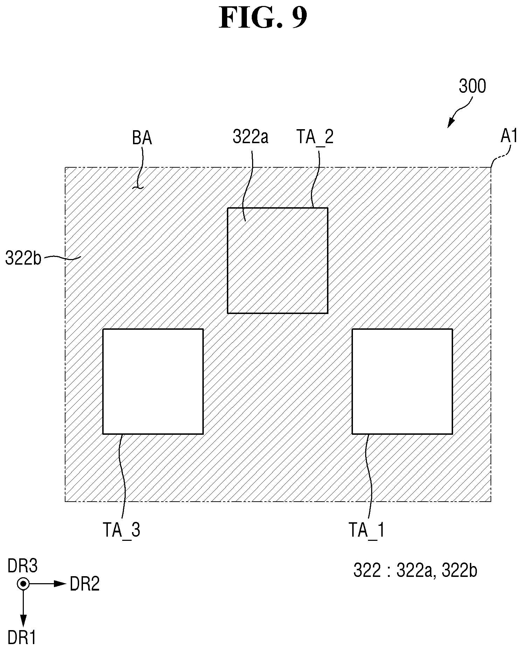

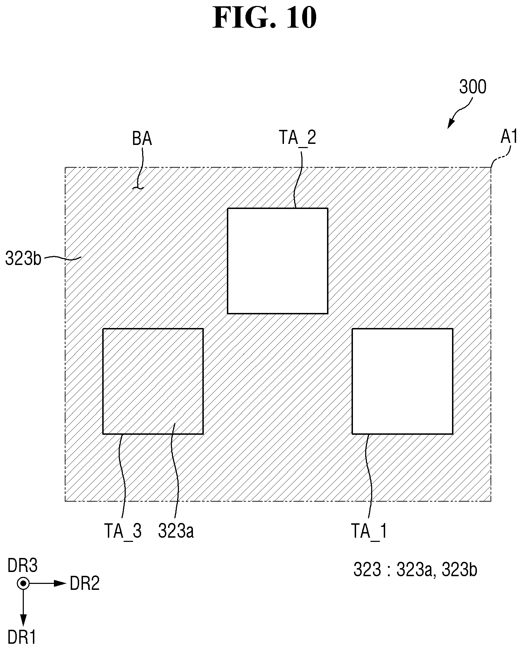

FIG. 4 is an enlarged plan view of area A1 of FIG. 3, more specifically, a schematic plan view of the light-emitting unit 100 included in the display device 1 of FIG. 3. FIG. 5 is an enlarged plan view of area A1 of FIG. 3, more specifically, a schematic plan view of the light-transmitting unit 300 included in the display device 1 of FIG. 3. FIG. 6 is a schematic cross-sectional view taken along line X2-X2' of FIGS. 4 and 5. FIG. 7 is an enlarged plan view of area A2 of FIG. 6. FIG. 8 is a plan view illustrating an embodiment of the schematic arrangement of a first color filter 321 of the color filter member 320 included in the light-transmitting unit 300 of the display device 1. FIG. 9 is a plan view illustrating an embodiment of the schematic arrangement of a second color filter 322 of the color filter member 320 included in the light-transmitting unit 300 of the display device 1. FIG. 10 is a plan view illustrating an embodiment of the schematic arrangement of a third color filter 323 of the color filter member 320 included in the light-transmitting unit 300 of the display device 1.

Referring to FIGS. 4 through 6 in addition to FIG. 3, a plurality of light-emitting areas may be defined in the light-emitting unit 100 of the display device 1 in the embodiment, and a plurality of light-transmitting areas may be defined in the light-transmitting unit 300.

The display area DA and the non-display area NDA defined in the display device 1 may be applied to the light-emitting unit 100 and the light-transmitting unit 300.

As illustrated in FIG. 4, a first light-emitting area ELA_1, a second light-emitting area ELA_2, and a third light-emitting area ELA_3 may be defined in the display area DA of the light-emitting unit 100. The first light-emitting area ELA_1, the second light-emitting area ELA_2, and the third light-emitting area ELA_3 may be areas where light generated by light-emitting elements of the light-emitting unit 100 is emitted to the outside of the light-emitting unit 100. A non-light-emitting area NELA may be an area where light is not emitted to the outside of the light-emitting unit 100. In some embodiments, the non-light-emitting area NELA may surround the first light-emitting area ELA_1, the second light-emitting area ELA_2, and the third light-emitting area ELA_3 in the display area DA, but the disclosure is limited thereto.

In some embodiments, light emitted from the first light-emitting area ELA_1, the second light-emitting area ELA_2 and the third light-emitting area ELA_3 to the outside may be light of a first color. In some embodiments, the light of the first color may be blue light and may have a peak wavelength in the range of about 440 nanometers (nm) to about 480 nm. Here, the peak wavelength refers to a wavelength at which the intensity of light is maximum.

In some embodiments, as illustrated in FIG. 4, the first light-emitting area ELA_1 and the third light-emitting area ELA_3 may be sequentially disposed along the second direction DR2, and the second light-emitting area ELA_2 may be disposed on a side of a space between the first light-emitting area ELA_1 and the third light-emitting area ELA_3. Accordingly, the first light-emitting area ELA_1, the second light-emitting area ELA_2, and the third light-emitting area ELA_3 may form one group. As illustrated in FIG. 3, one group formed by the first light-emitting area ELA_1, the second light-emitting area ELA_2, and the third light-emitting area ELA_3 may be repeatedly disposed along the first direction DR1 and the second direction DR2 in the display area DA. However, the disclosure is not limited thereto. In an embodiment, the arrangement of the first light-emitting area ELA_1, the second light-emitting area ELA_2, and the third light-emitting area ELA_3 may be variously changed such that the first light-emitting area ELA_1, the second light-emitting area ELA_2, and the third light-emitting area ELA_3 are sequentially disposed along the second direction DR2, for example. For ease of description, a case where the first light-emitting area ELA_1, the second light-emitting area ELA_2, and the third light-emitting area ELA_3 are disposed as illustrated in FIG. 4 will be described below as one of embodiments.

In some embodiments, the area of the first light-emitting area ELA_1, the area of the second light-emitting area ELA_2, and the area of the third light-emitting area ELA_3 may be substantially the same. However, the disclosure is not limited thereto. In an embodiment, the area of the first light-emitting area ELA_1, the area of the second light-emitting area ELA_2, and the area of the third light-emitting area ELA_3 may be different from each other, for example. In some embodiments, the first light-emitting area ELA_1, the second light-emitting area ELA_2, and the third light-emitting area ELA_3 may have a rectangular (e.g., square) planar shape, but the disclosure is not limited thereto. For ease of description, a case where the first light-emitting area ELA_1, the second light-emitting area ELA_2, and the third light-emitting area ELA_3 have a rectangular planar shape and have substantially the same area will be mainly described below.

A first light-transmitting area TA_1, a second light-transmitting area TA_2, and a third light-transmitting area TA_3 may be defined in the display area DA of the light-transmitting unit 300. The first light-transmitting area TA_1, the second light-transmitting area TA_2, and the third light-emitting area TA_3 may be areas through which light generated in the first light-emitting area ELA_1, the second light-emitting area ELA_2, and the third light-emitting area ELA_3 of the light-emitting unit 100 is transmitted. A light-blocking area BA may be disposed around the first light-transmitting area TA_1, the second light-transmitting area TA_2, and the third light-transmitting area TA_3 in the display area DA of the light-transmitting unit 300. In some embodiments, the light-blocking area BA may surround the first light-transmitting area TA_1, the second light-transmitting area TA_2, and the third light-transmitting area TA_3. However, the disclosure is not limited thereto. In an embodiment, the light-blocking area BA may be disposed in the non-display area NDA as well as in the display area DA of the light-transmitting unit 300, for example.

The first light-transmitting area TA_1 may correspond to and overlap the first light-emitting area ELA_1, the second light-transmitting area TA_2 may correspond to and overlap the second light-emitting area ELA_2, and the third light-transmitting area TA_3 may correspond to and overlap the third light-emitting area ELA_3. In some embodiments, the first light-transmitting area TA_1 may have substantially the same area as that of the first light-emitting area ELA_1 to completely overlap the first light-emitting area ELA_1, the second light-transmitting area TA_2 may have substantially the same area as that of the second light-emitting area ELA_2 to completely overlap the second light-emitting area ELA_2, and the third light-transmitting area TA_3 may have substantially the same area as that of the third light-emitting area ELA_3 to completely overlap the third light-emitting area ELA_3. However, the disclosure is not limited thereto. In an embodiment, the first light-transmitting area TA_1 may also have a different area from the first light-emitting area ELA_1, the second light-transmitting area TA_2 may also have a different area from the second light-emitting area ELA_2, and the third light-transmitting area TA_3 may also have a different area from the third light-emitting area ELA_3, for example. For ease of description, a case where the first light-transmitting area TA_1 has substantially the same area as that of the first light-emitting area ELA_1 to completely overlap the first light-emitting area ELA_1, the second light-transmitting area TA_2 has substantially the same area as that of the second light-emitting area ELA_2 to completely overlap the second light-emitting area ELA_2, and the third light-transmitting area TA_3 has substantially the same area as that of the third light-emitting area ELA_3 to completely overlap the third light-emitting area ELA_3 will be mainly described below.

The first light-transmitting area TA_1 and the third light-transmitting area TA_3 may be sequentially disposed along the second direction DR2, and the second light-transmitting area TA_2 may be disposed on a side of a space between the first light-transmitting area TA_1 and the third light-transmitting area TA_3. Accordingly, the first light-transmitting area TA_1, the second light-transmitting area TA_2, and the third light-transmitting area TA_3 may form one group. As illustrated in FIG. 3, one group formed by the first light-transmitting area TA_1, the second light-transmitting area TA_2, and the third light-transmitting area TA_3 may be repeatedly disposed along the first direction DR1 and the second direction DR2 in the display area DA.

As described above, light of the first color emitted from the light-emitting unit 100 may be provided to the outside of the display device 1 through the first light-transmitting area TA_1, the second light-transmitting area TA_2, and the third light-transmitting area TA_3. Light emitted from the first light-transmitting area TA_1 to the outside of the display device 1 may be also referred to as first output light, light emitted from the second light-transmitting area TA_2 to the outside of the display device 1 may be also referred to as second output light, and light emitted from the third light-transmitting area TA_3 to the outside of the display device 1 may be also referred to as third output light. In this case, the first output light may be light of the first color, the second output light may be light of a second color, and the third output light may be light of a third color.

In some embodiments, the light of the first color may be blue light having a peak wavelength in the range of about 440 nm to about 480 nm as described above, and the light of the second color may be green light having a peak wavelength in the range of about 510 nm to about 550 nm. In addition, the light of the third color may be red light having a peak wavelength in the range of about 610 nm to about 650 nm.

The structure of the display device 1 will now be described in detail.

Referring to FIG. 6, as described above, the display device 1 may include the light-emitting unit 100, the light-transmitting unit 300 disposed on the light-emitting unit 100 to face the light-emitting unit 100, and the filler 500 interposed between the light-emitting unit 100 and the light-transmitting unit 300. For ease of explanation, the light-emitting unit 100, the light-transmitting unit 300, and the filler 500 will be described below in this order.

The light-emitting unit 100 may have a structure in which a first substrate 110, a buffer layer 120, bottom metal layers BML, a first insulating layer 130, semiconductor layers ACT, gate electrodes GE, gate insulating layers 140, a second insulating layer 150, source/drain electrodes, a third insulating layer 160, light-emitting elements, a pixel defining layer 170, a first capping layer CPL1, and a thin-film encapsulation layer are sequentially stacked to the first side in the third direction DR3.

The first substrate 110 of the light-emitting unit 100 may serve as a base of the light-emitting unit 100. The first substrate 110 may include or consist of a light-transmitting material. The first substrate 110 may be a glass substrate or a plastic substrate. When the first substrate 110 is a plastic substrate, it may have flexibility. In some embodiments, when the first substrate 110 is a plastic substrate, it may include, but is not limited to, polyimide.

The buffer layer 120 of the light-emitting unit 100 may be disposed on the first substrate 110. The buffer layer 120 may block foreign matter or moisture introduced through the first substrate 110 from entering elements disposed on the buffer layer 120.

In some embodiments, the buffer layer 120 may include an inorganic material such as SiO₂, SiNₓ or SiON and may be formed as a single layer or a multilayer, but the disclosure is not limited thereto.

The bottom metal layers BML of the light-emitting unit 100 may be disposed on the buffer layer 120. The bottom metal layers BML may block external light or light emitted from the light-emitting elements to be described later from entering the semiconductor layers ACT. Accordingly, the bottom metal layers BML may prevent or reduce generation of leakage current due to light in thin-film transistors to be described later.

The bottom metal layers BML may include or consist of a material that blocks light and has conductivity. In some embodiments, the bottom metal layers BML may include a single material selected from metals such as silver (Ag), nickel (Ni), gold (Au), platinum (Pt), aluminum (Al), copper (Cu), molybdenum (Mo), titanium (Ti) and neodymium (Nd) or may include an alloy of the metals. In some embodiments, the bottom metal layers BML may have a single-layer structure or a multilayer structure. In an embodiment, when the bottom metal layers BML have a multilayer structure, each of the bottom metal layers BML may be, but is not limited to, a stacked structure of titanium (Ti)/copper (Cu)/indium tin oxide ("ITO") or a stacked structure of titanium (Ti)/copper (Cu)/aluminum oxide (Al₂O₃), for example.

In some embodiments, the bottom metal layers BML may correspond to the semiconductor layers ACT and overlap the semiconductor layers ACT, respectively. In some embodiments, the bottom metal layers BML may be wider than the semiconductor layers ACT.

In some embodiments, the bottom metal layers BML may be part of data lines, power supply lines, and wirings that electrically connect thin-film transistors not illustrated in the drawing to the thin-film transistors (GE, ACT, DE and SE in FIG. 6) illustrated in the drawing. In some embodiments, the bottom metal layers BML may include or consist of a material having a lower resistance than those of source electrodes SE and drain electrodes DE.

The first insulating layer 130 of the light-emitting unit 100 may be disposed on the bottom metal layers BML. The first insulating layer 130 may electrically insulate the bottom metal layers BML from the semiconductor layers ACT. The first insulating layer 130 may cover the bottom metal layers BML.

In some embodiments, the first insulating layer 130 may include, but is not limited to, an inorganic material such as SiO₂, SiNₓ, SiON, Al₂O₃, TiO₂, Ta₂O, HfO₂, or ZrO₂.

The semiconductor layers ACT of the light-emitting unit 100 may be disposed on the first insulating layer 130. The semiconductor layers ACT may respectively correspond to the first light-emitting area ELA_1, the second light-emitting area ELA_2, and the third light-emitting area ELA_3 in the display area DA of the light-emitting unit 100. In addition, the semiconductor layers ACT may respectively overlap the bottom metal layers BML, thereby suppressing generation of a photocurrent in the semiconductor layers ACT.

The semiconductor layers ACT may include an oxide semiconductor. In some embodiments, each of the semiconductor layers ACT may include or consist of a Zn oxide-based material such as Zn oxide, In-Zn oxide or Ga-In-Zn oxide or may also be an In-Ga-Zn-O ("IGZO") semiconductor including or consisting of metals such as indium (In) and gallium (Ga) in ZnO. However, the disclosure is not limited thereto. In an embodiment, the semiconductor layers ACT may also include amorphous silicon or polysilicon, for example.

The gate electrodes GE of the light-emitting unit 100 may be disposed on the semiconductor layers ACT. The gate electrodes GE may overlap the semiconductor layers ACT in the display area DA. In some embodiments, the gate electrodes GE may be narrower than the semiconductor layers ACT, but the disclosure is not limited thereto.

In some embodiments, in consideration of adhesion to an adjacent layer, surface flatness of a layer to be stacked, and workability, each of the gate electrodes GE may include one or more of aluminum (Al), platinum (Pt), palladium (Pd), silver (Ag), magnesium (Mg), gold (Au), nickel (Ni), neodymium (Nd), iridium (Ir), chromium (Cr), lithium (Li), calcium (Ca), molybdenum (Mo), titanium (Ti), tungsten (W) and copper (Cu) and may be formed as a single layer or a multilayer, but the disclosure is not limited thereto.

The gate insulating layers 140 of the light-emitting unit 100 may be disposed between the semiconductor layers ACT and the gate electrodes GE. The gate insulating layers 140 may insulate the semiconductor layers ACT from the gate electrodes GE. In some embodiments, the gate insulating layers 140 may have a partially patterned shape instead of being formed as one layer disposed on a surface of the first substrate 110 on the first side in the third direction DR3. The gate insulating layers 140 may be narrower than the semiconductor layers ACT and may be wider than the gate electrodes GE, but the disclosure is not limited thereto.

In some embodiments, the gate insulating layers 140 may include an inorganic material. In an embodiment, the gate insulating layers 140 may include one of the inorganic materials exemplified in the description of the first insulating layer 130, for example.

The second insulating layer 150 of the light-emitting unit 100 may be disposed on the gate insulating layers 140 to cover the semiconductor layers ACT and the gate electrodes GE. In some embodiments, the second insulating layer 150 may function as a planarization layer that provides a flat surface.

The second insulating layer 150 may include an organic material. In some embodiments, the second insulating layer 150 may include, but is not limited to, at least any one of photo acryl ("PAC"), polystyrene, polymethyl methacrylate ("PMMA"), polyacrylonitrile ("PAN"), polyamide, polyimide, polyarylether, heterocyclic polymer, parylene, fluorine-based polymer, epoxy resin, benzocyclobutene series resin, siloxane series resin, and silane resin.

The source electrodes SE and the drain electrodes DE of the light-emitting unit 100 may be spaced apart from each other and disposed on the second insulating layer 150. The source electrodes SE and the drain electrodes DE may be connected to the semiconductor layers ACT respectively through contact holes penetrating the second insulating layer 150. In some embodiments, the source electrodes SE may penetrate the first insulating layer 130 as well as the second insulating layer 150 and thus may be connected to the bottom metal layers BML. When the bottom metal layers BML are part of wirings that transmit signals or voltages, the source electrodes SE may be connected and electrically coupled to the bottom metal layers BML to receive voltages provided to the wirings. In an alternative embodiment, when the bottom metal layers BML are floating patterns rather than wirings, voltages applied to the source electrodes SE may be transmitted to the bottom metal layers BML.

Each of the source electrodes SE and the drain electrodes DE may include aluminum (Al), copper (Cu), titanium (Ti), or the like and may be formed as a multilayer or a single layer. In some embodiments, the source electrodes SE and the drain electrodes DE may have, but are not limited to, a multilayer structure of Ti/Al/Ti.

The semiconductor layers ACT, the gate electrodes GE, the source electrodes SE, and the drain electrodes DE described above may form thin-film transistors which are switching elements. In some embodiments, the thin-film transistors may be disposed in the first light-emitting area ELA_1, the second light-emitting area ELA_2, and the third light-emitting area ELA_3, respectively. In some embodiments, a portion of each of the thin-film transistors may be disposed in the non-light-emitting area NELA.

The third insulating layer 160 of the light-emitting unit 100 may be disposed on the second insulating layer 150 to cover the thin-film transistors. In some embodiments, the third insulating layer 160 may be a planarization layer.

The third insulating layer 160 may include or consist of an organic material. In some embodiments, the third insulating layer 160 may include acrylic resin, epoxy resin, imide resin or ester resin or may include a photosensitive organic material, but the disclosure is not limited thereto.

Anodes ANO may be disposed on the third insulating layer 160 in the display area DA of the light-emitting unit 100.

The anodes ANO may overlap the first light-emitting area ELA_1, the second light-emitting area ELA_2 and the third light-emitting area ELA_3, respectively, and at least a portion of each of the anodes ANO may extend to the non-light-emitting area NELA. The anodes ANO may be connected to the drain electrodes DE of the thin-film transistors.

In some embodiments, the anodes ANO may be reflective electrodes. In this case, each of the anodes ANO may be a metal layer including a metal such as Ag, Mg, Al, Pt, Pd, Au, Ni, Nd, Ir or Cr. In an embodiment, each of the anodes ANO may further include a metal oxide layer stacked on the metal layer. In an embodiment, the anodes ANO may have a multilayer structure, e.g., a two-layer structure of ITO/Ag, Ag/ITO, ITO/Mg or ITO/MgF or a three-layer structure of ITO/Ag/ITO.

The pixel defining layer 170 of the light-emitting unit 100 may be disposed on the anodes ANO. The pixel defining layer 170 may include openings exposing the anodes ANO to define first light-emitting area ELA_1, the second light-emitting area ELA_2 and the third light-emitting area ELA_3.

The pixel defining layer 170 may overlap the light-blocking area BA of the color filter member 320, which will be described later, in the third direction DR3. In addition, the pixel defining layer 170 may overlap a bank layer BK, which will be described later, in the third direction DR3.

In some embodiments, the pixel defining layer 170 may include, but is not limited to, an organic insulating material such as polyacrylates resin, epoxy resin, phenolic resin, polyamides resin, polyimides resin, unsaturated polyesters resin, polyphenylenethers resin, polyphenylenesulfides resin, or benzocyclobutene ("BCB").

A light-emitting layer OL of the light-emitting unit 100 may be disposed on the anodes ANO. In some embodiments, the light-emitting layer OL may be in the shape of a continuous layer formed over the light-emitting areas ELA_1 through ELA_3 and the non-light-emitting area NELA. In some embodiments, the light-emitting layer OL may be disposed only in the display area DA. However, the disclosure is not limited thereto. In an embodiment, a portion of the light-emitting layer OL may be further disposed in the non-display area NDA, for example. The light-emitting layer OL will be described in more detail later.

A cathode CE of the light-emitting unit 100 may be disposed on the light-emitting layer OL. In some embodiments, the cathode CE may be disposed on the light-emitting layer OL and may be in the shape of a continuous layer formed over the light-emitting areas ELA_1 through ELA_3 and the non-light-emitting area NELA. In other words, the cathode CE may completely cover the light-emitting layer OL.

The cathode CE may have translucency or transparency. When a thickness of the cathode CE is tens to hundreds of angstroms, the cathode CE may have translucency. In some embodiments, when the cathode CE has translucency, it may include Ag, Mg, Cu, Al, Pt, Pd, Au, Ni, Nd, Ir, Cr, Li, Ca, LiF/Ca, LiF/Al, Mo, Ti, or any compounds or any combinations thereof (e.g., a combination of Ag and Mg). The cathode CE may also have transparency by including a transparent conductive oxide. In some embodiments, when the cathode CE has transparency, it may include tungsten oxide (WₓOₓ), titanium oxide (TiO₂), indium tin oxide ("ITO"), indium zinc oxide ("IZO"), zinc oxide (ZnO), indium tin zinc oxide ("ITZO"), or magnesium oxide (MgO).

The anodes ANO, the light-emitting layer OL, and the cathode CE may form light-emitting elements. In an embodiment, the anode ANO, the light-emitting layer OL and the cathode CE overlapping the first light-emitting area ELA_1 may form a first light-emitting element, the anode ANO, the light-emitting layer OL and the cathode CE overlapping the second light-emitting area ELA_2 may form a second light-emitting element, and the anode ANO, the light-emitting layer OL and the cathode CE overlapping the third light-emitting area ELA_3 may form a third light-emitting element, for example. Each of the first light-emitting element, the second light-emitting element, and the third light-emitting element may emit output light LE.

Referring to FIG. 7, the output light LE finally emitted from the light-emitting layer OL may be a combination of a first component LE1 and a second component LE2. Each of the first component LE1 and the second component LE2 in the output light LE may have a peak wavelength in the range of about 440 nm to less than about 480 nm. That is, the output light LE may be blue light.

In some embodiments, the light-emitting layer OL may have a structure in which a plurality of light-emitting material layers overlap as illustrated in FIG. 7 may have a tandem structure, for example. In an embodiment, the light-emitting layer OL may include a first stack ST1 including a first light-emitting material layer EMI,1, a second stack ST2 disposed on the first stack ST1 and including a second light-emitting material layer EML2, a third stack ST3 disposed on the second stack ST2 and including a third light-emitting material layer EML3, a first charge generation layer CGL1 disposed between the first stack ST1 and the second stack ST2, and a second charge generation layer CGL2 disposed between the second stack ST2 and the third stack ST3, for example. The first stack ST1, the second stack ST2, and the third stack ST3 may overlap each other.

The first light-emitting material layer EML1, the second light-emitting material layer EML2, and the third light-emitting material layer EML3 may overlap each other.

In some embodiments, the first light-emitting material layer EMI,1, the second light-emitting material layer EML2, and the third light-emitting material layer EML3 may all emit light of the first color, e.g., blue light. In an embodiment, each of the first light-emitting material layer EML1, the second light-emitting material layer EML2, and the third light-emitting material layer EML3 may be a blue light-emitting layer and may include an organic material, for example.

In some embodiments, at least any one of the first light-emitting material layer EMI,1, the second light-emitting material layer EML2 and the third light-emitting material layer EML3 may emit first blue light having a first peak wavelength, and at least another one of the first light-emitting material layer EMI,1, the second light-emitting material layer EML2 and the third light-emitting material layer EML3 may emit second blue light having a second peak wavelength different from the first peak wavelength. In an embodiment, any one of the first light-emitting material layer EML1, the second light-emitting material layer EML2 and the third light-emitting material layer EML3 may emit the first blue light having the first peak wavelength, and the other two of the first light-emitting material layer EML1, the second light-emitting material layer EML2 and the third light-emitting material layer EML3 may emit the second blue light having the second peak wavelength, for example. That is, the output light LE finally emitted from the light-emitting layer OL may be a combination of the first component LE1 and the second component LE2. Here, the first component LE1 may be the first blue light having the first peak wavelength, and the second component LE2 may be the second blue light having the second peak wavelength.

In some embodiments, any one of the first peak wavelength and the second peak wavelength may be in the range of about 440 nm to less than about 460 nm. The other one of the first peak wavelength and the second peak wavelength may be in the range of about 460 nm to about 480 nm. However, the range of the first peak wavelength and the range of the second peak wavelength are not limited to this example. In an embodiment, both the range of the first peak wavelength and the range of the second peak wavelength may include about 460 nm, for example. In some embodiments, any one of the first blue light and the second blue light may be light of a deep blue color, and the other one of the first blue light and the second blue light may be light of a sky blue color.

In some embodiments, the output light LE emitted from the light-emitting layer OL may be blue light and may include a long wavelength component and a short wavelength component. Therefore, the light-emitting layer OL may finally emit blue light having a broader emission peak as the output light LE, thereby improving color visibility at a side viewing angle compared with a conventional light-emitting element that emits blue light having a sharp emission peak.

In some embodiments, each of the first light-emitting material layer EMI,1, the second light-emitting material layer EML2, and the third light-emitting material layer EML3 may include a host and a dopant. The host is not particularly limited as long as it is a commonly used material. In an embodiment, tris(8-hydroxyquinolino)aluminum (Alq3), 4,4'-bis(N-carbazolyl)-1,1'-biphenyl ("CBP"), poly(n-vinylcabazole) ("PVK"), ADN, 4,4',4"-tris(carbazol-9-yl)-triphenylamine ("TCTA"), 1,3,5-tris(N-phenylbenzimidazole-2-yl)benzene (TPBi), 3-tert-butyl-9,10-di(naphth-2-yl)anthracene ("TBADN"), distyrylarylene ("DSA"), 4,4'-bis(9-carbazolyl)-2,2'-dimethyl-biphenyl ("CDBP"), or 2-methyl-9,10-bis(naphthalen-2-yl)anthracene) ("MADN") may be used.

Each of the first light-emitting material layer EMI,1, the second light-emitting material layer EML2, and the third light-emitting material layer EML3 which emit blue light may include, e.g., a fluorescent material including any one of spiro-DPVBi, spiro-6P, distyryl-benzene ("DSB"), DSA, a polyfluorene ("PFO")-based polymer, and a poly (p-phenylene vinylene) ("PPV")-based polymer, for example. In an alternative embodiment, a phosphorescent material including an organometallic complex such as (4,6-F2ppy)2Irpic may be included.

As described above, at least one of the first light-emitting material layer EMI,1, the second light-emitting material layer EML2 and the third light-emitting material layer EML3 and at least another one of the first light-emitting material layer EML1, the second light-emitting material layer EML2 and the third light-emitting material layer EML3 emit blue light in different wavelength ranges. To emit blue light in different wavelength ranges, the first light-emitting material layer EML1, the second light-emitting material layer EML2 and the third light-emitting material layer EML3 may include the same material, and a method of adjusting a resonance distance may be used. In an alternative embodiment, to emit blue light in different wavelength ranges, at least one of the first light-emitting material layer EMI,1, the second light-emitting material layer EML2 and the third light-emitting material layer EML3 and at least another one of the first light-emitting material layer EMI,1, the second light-emitting material layer EML2 and the third light-emitting material layer EML3 may include different materials.

However, the disclosure is not limited thereto. The first light-emitting material layer EML1, the second light-emitting material layer EML2 and the third light-emitting material layer EML3 may all emit blue light having a peak wavelength of about 440 nm to about 480 nm and may include or consist of the same material.

In an alternative embodiment, in an embodiment, at least any one of the first light-emitting material layer EML1, the second light-emitting material layer EML2 and the third light-emitting material layer EML3 may emit the first blue light having the first peak wavelength, another one of the first light-emitting material layer EMI,1, the second light-emitting material layer EML2 and the third light-emitting material layer EML3 may emit the second blue light having the second peak wavelength different from the first peak wavelength, and the other one of the first light-emitting material layer EML1, the second light-emitting material layer EML2 and the third light-emitting material layer EML3 may emit third blue light having a third peak wavelength different from the first peak wavelength and the second peak wavelength. In some embodiments, any one of the first peak wavelength, the second peak wavelength and the third peak wavelength may be in the range of about 440 nm to less than about 460 nm. Another one of the first peak wavelength, the second peak wavelength and the third peak wavelength may be in the range of about 460 nm to less than about 470 nm, and the other one of the first peak wavelength, the second peak wavelength and the third peak wavelength may be in the range of about 470 nm to about 480 nm.

In some embodiments, the output light LE emitted from the light-emitting layer OL is blue light and includes a long wavelength component, a medium wavelength component and a short wavelength component. Therefore, the light-emitting layer OL may finally emit blue light having a broader emission peak as the output light LE and improve color visibility at a side viewing angle.

According to the above-described embodiments, it is possible to improve light efficiency and extend the life of the display device 1 as compared with a conventional light-emitting element that does not employ a tandem structure, that is, a structure in which a plurality of light-emitting material layers are stacked.

In alternative embodiments, at least any one of the first light-emitting material layer EMI,1, the second light-emitting material layer EML2 and the third light-emitting material layer EML3 may emit light of the first color, e.g., blue light, and at least another one of the first light-emitting material layer EML1, the second light-emitting material layer EML2 and the third light-emitting material layer EML3 may emit light of the second color, e.g., green light. In some embodiments, blue light emitted from at least any one of the first light-emitting material layer EML1, the second light-emitting material layer EML2, and the third light-emitting material layer EML3 may have a peak wavelength in the range of about 440 nm to about 480 nm or about 460 nm to about 480 nm. Green light emitted from at least another one of the first light-emitting material layer EMI,1, the second light-emitting material layer EML2, and the third light-emitting material layer EML3 may have a peak wavelength in the range of about 510 nm to about 550 nm.

In an embodiment, any one of the first light-emitting material layer EMI,1, the second light-emitting material layer EML2 and the third light-emitting material layer EML3 may emit a green light, and the other two of the first light-emitting material layer EML1, the second light-emitting material layer EML2 and the third light-emitting material layer EML3 may emit blue light, for example. When the other two of the first light-emitting material layer EML1, the second light-emitting material layer EML2 and the third light-emitting material layer EML3 are emitting blue light, peak wavelengths of blue light emitted from each of the two light-emitting material layer may be in the same range or in different ranges.

In some embodiments, the output light LE emitted from the light-emitting layer OL may be a combination of the first component LE1 which is blue light and the second component LE2 which is green light. In an embodiment, when the first component LE1 is dark blue light and the second component LE2 is green light, the output light LE may be light having a sky blue color, for example. As in the above-described embodiments, the output light LE emitted from the light-emitting layer OL, which is a combination of blue light and green light, includes a long wavelength component and a short wavelength component. Therefore, the light-emitting layer OL may finally emit blue light having a broader emission peak as the output light LE and improve color visibility at a side viewing angle. In addition, since the second component LE2 of the output light LE is green light, a green light component of the light provided from the display device 1 to the outside may be supplemented. Accordingly, the color reproducibility of the display device 1 may be improved.

In some embodiments, a green light-emitting material layer among the first light-emitting material layer EMI,1, the second light-emitting material layer EML2, and the third light-emitting material layer EML3 may include a host and a dopant. The host included in the green light-emitting material layer is not particularly limited as long as it is a commonly used material. In an embodiment, for example, tris(8-hydroxyquinolino)aluminum (Alq3), CBP, PVK, ADN, TCTA), 1,3,5-tris(N-phenylbenzimidazole-2-yl)benzene (TPBi), TBADN, DSA, CDBP, or MADN may be used, for example.

The dopant included in the green light-emitting material layer may be a fluorescent material including tris-(8-hydroyquinolato) aluminum(III) (Alq3) or may be a phosphorescent material such as Ir(ppy)3(fac tris(2-phenylpyridine)iridium), Ir(ppy)2(acac)(Bis(2-phenylpyridine)(acetylacetonate)iridium(III)) or Ir(mpyp)3(2-phenyl-4-methyl-pyridine iridium), for example.

The first charge generation layer CGL1 may be disposed between the first stack ST1 and the second stack ST2. The first charge generation layer CGL1 may inject electric charges into each light-emitting material layer. The first charge generation layer CGL1 may control the charge balance between the first stack ST1 and the second stack ST2. The first charge generation layer CGL1 may include an n-type charge generation layer CGL11 and a p-type charge generation layer CGL12. The p-type charge generation layer CGL12 may be disposed on the n-type charge generation layer CGL11 and may be disposed between the n-type charge generation layer CGL11 and the second stack ST2.

The first charge generation layer CGL1 may have a structure in which the n-type charge generation layer CGL11 and the p-type charge generation layer CGL12 contact each other. The n-type charge generation layer CGL11 is disposed closer to an anode ANO among the anode ANO and the cathode CE. The p-type charge generation layer CGL12 is disposed closer to the cathode CE among the anode ANO and the cathode CE. The n-type charge generation layer CGL11 supplies electrons to the first light-emitting material layer EML1 adjacent to the anode ANO, and the p-type charge generation layer CGL12 supplies holes to the second light-emitting material layer EML2 included in the second stack ST2. Since the first charge generation layer CGL1 is disposed between the first stack ST1 and the second stack ST2 to provide electric charges to each light-emitting material layer, luminous efficiency may be improved, and a driving voltage may be lowered.

The first stack ST1 may be disposed on a first anode ANO_1, a second anode ANO_2 and a third anode ANO_3 and may further include a first hole transport layer HTL1, a first electron blocking layer BIL1 and a first electron transport layer ETL1.

The first hole transport layer HTL1 may be disposed on the first anode ANO_1, the second anode ANO_2, and the third anode ANO_3. The first hole transport layer HTL1 may facilitate the transportation of holes and may include a hole transport material. The hole transport material may include, but is not limited to, a carbazole derivative such as N-phenylcarbazole or polyvinylcarbazole, a fluorene derivative, a triphenylamine derivative such as N,N'-bis(3-methylphenyl)-N,N'-diphenyl-[1,1-biphenyl]-4,4'-diamine ("TPD") or 4,4',4"-tris(N-carbazolyl)triphenylamine ("TCTA"), N,N'-di(1-naphthyl)-N,N'-diphenylbenzidine) ("NPB"), or 4,4'-Cyclohexylidene bis[N,N-bis(4-methylphenyl)benzenamine] ("TAPC").

The first electron blocking layer BIL1 may be disposed on the first hole transport layer HTL1 and may be disposed between the first hole transport layer HTL1 and the first light-emitting material layer EML1. The first electron blocking layer BIL1 may include a hole transport material and a metal or a metal compound in order to prevent electrons generated by the first light-emitting material layer EML1 from entering the first hole transport layer HTL1. In some embodiments, the first hole transport layer HTL1 and the first electron blocking layer BIL1 described above may be formed as a single layer in which their respective materials are mixed.

The first electron transport layer ETL1 may be disposed on the first light-emitting material layer EML1 and may be disposed between the first charge generation layer CGL1 and the first light-emitting material layer EML1. In some embodiments, the first electron transport layer ETL1 may include an electron transport material such as tris-(8-hydroxyquinolinato)aluminum (Alq3), 1,3,5-tri(1-phenyl-1H-benzo[d]imidazol-2-yl)phenyl (TPBi), 2,9-dimethyl-4,7-diphenyl-1,10-phenanthroline ("BCP"), 4,7-diphenyl-1,10-phenanthroline (Bphen), 3-(4-biphenyl)-4-phenyl-5-tert-butylphenyl-1,2,4-triazole ("TAZ"), 4-(naphthalen-1-yl)-3,5-diphenyl-4H-1,2,4-triazole ("NTAZ"), 2-(4-biphenylyl)-5-(4-tert-butylphenyl)-1,3,4-oxadiazole (tBu-PBD), bis(2-methyl-8-quinolinolato-N1,O8)-(1,1'-biphenyl-4-olato)aluminum (BAlq), berylliumbis(benzoquinolin-10-olate) (Bebq2), ADN, or any combinations thereof. However, the disclosure is not limited to the type of the electron transport material. The second stack ST2 may be disposed on the first charge generation layer CGL1 and may further include a second hole transport layer HTL2, a second electron blocking layer BIL2 and a second electron transport layer ETL2.

The second hole transport layer HTL2 may be disposed on the first charge generation layer CGL1. The second hole transport layer HTL2 may include or consist of the same material as that of the first hole transport layer HTL1 or may include one or more materials selected from the materials exemplified as the materials included in the first hole transport layer HTL1. The second hole transport layer HTL2 may consist of a single layer or a plurality of layers.

The second electron blocking layer BIL2 may be disposed on the second hole transport layer HTL2 and may be disposed between the second hole transport layer HTL2 and the second light-emitting material layer EML2. The second electron blocking layer BIL2 may have the same material and structure as those of the first electron blocking layer BIL1 or may include one or more materials selected from the materials exemplified as the materials included in the first electron blocking layer BII,1.

The second electron transport layer ETL2 may be disposed on the second light-emitting material layer EML2 and may be disposed between the second charge generation layer CGL2 and the second light-emitting material layer EML2. The second electron transport layer ETL2 may have the same material and structure as those of the first electron transport layer ETL1 or may include one or more materials selected from the materials exemplified as the materials included in the first electron transport layer ETL1. The second electron transport layer ETL2 may consist of a single layer or a plurality of layers.

The second charge generation layer CGL2 may be disposed on the second stack ST2 and may be disposed between the second stack ST2 and the third stack ST3.

The second charge generation layer CGL2 may have the same structure as that of the first charge generation layer CGL1 described above. In an embodiment, the second charge generation layer CGL2 may include an n-type charge generation layer CGL21 disposed closer to the second stack ST2 and a p-type charge generation layer CGL22 disposed closer to the cathode CE, for example. The p-type charge generation layer CGL22 may be disposed on the n-type charge generation layer CGL21.

The second charge generation layer CGL2 may have a structure in which the n-type charge generation layer CGL21 and the p-type charge generation layer CGL22 contact each other. The first charge generation layer CGL1 and the second charge generation layer CGL2 may include or consist of different materials or the same material.

The third stack ST3 may be disposed on the second charge generation layer CGL2 and may further include a third hole transport layer HTL3 and a third electron transport layer ETL3.

The third hole transport layer HTL3 may be disposed on the second charge generation layer CGL2. The third hole transport layer HTL3 may include or consist of the same material as that of the first hole transport layer HTL1 or may include one or more materials selected from the materials exemplified as the materials included in the first hole transport layer HTL1. The third hole transport layer HTL3 may consist of a single layer or a plurality of layers. When the third hole transport layer HTL3 consists of a plurality of layers, the layers may include different materials.

The third electron transport layer ETL3 may be disposed on the third light-emitting material layer EML3 and may be disposed between the cathode CE and the third light-emitting material layer EML3. The third electron transport layer ETL3 may have the same material and structure as those of the first electron transport layer ETL1 or may include one or more materials selected from the materials exemplified as the materials included in the first electron transport layer ETL1. The third electron transport layer ETL3 may consist of a single layer or a plurality of layers. When the third electron transport layer ETL3 consists of a plurality of layers, the layers may include different materials.

Although not illustrated in the drawing, a hole injection layer may be further disposed in at least any one of the spaces between the first stack ST1 and the first anode ANO_1, between the second anode ANO_2 and the third anode ANO _3, between the second stack ST2 and the first charge generation layer CGL1, and between the third stack ST3 and the second charge generation layer CGL2. The hole injection layer may facilitate the injection of holes into the first light-emitting material layer EML1, the second light-emitting material layer EML2 and the third light-emitting material layer EML3. In some embodiments, the hole injection layer may include or consist of, but not limited to, any one or more of copper phthalocyanine (CuPc), poly(3,4-ethylenedioxythiphene) ("PEDOT"), polyaniline ("PANI"), and N,N-dinaphthyl-N,N'-diphenyl benzidine ("NPD"). In some embodiments, the hole injection layer may be disposed between the first stack ST1 and the first anode ANO_1, between the second anode ANO_2 and the third anode ANO_3, between the second stack ST2 and the first charge generation layer CGL1, and between the third stack ST3 and the second charge generation layer CGL2.

Although not illustrated in the drawing, an electron injection layer may be further disposed in at least any one of the spaces between the third electron transport layer ETL3 and the cathode CE, between the second charge generation layer CGL2 and the second stack ST2, and between the first charge generation layer CGL1 and the first stack ST1. The electron injection layer may facilitate the injection of electrons and may use tris(8-hydroxyquinolino)aluminum) (Alq3), PBD, TAZ, spiro-PBD, BAIq or SAlq, but the disclosure is not limited thereto. In addition, the electron injection layer may be a metal halide compound, e.g., any one or more of MgF₂, LiF, NaF, KF, RbF, CsF, FrF, LiI, NaI, KI, RbI, CsI, FrI and CaF₂, but the disclosure is not limited thereto. In an alternative embodiment, the electron injection layer may include a lanthanum material such as Yb, Sm, or Eu. In an alternative embodiment, the electron injection layer may include both a metal halide material and a lanthanum material such as RbI:Yb or KI:Yb. When the electron injection layer includes both a metal halide material and a lanthanum material, the electron injection layer may be formed by co-deposition of the metal halide material and the lanthanum material. In some embodiments, the electron injection layer may be disposed between the third electron transport layer ETL3 and the cathode CE, between the second charge generation layer CGL2 and the second stack ST2, and between the first charge generation layer CGL1 and the first stack ST1.

In some embodiments, the light-emitting layer OL may not include a red light-emitting material layer and thus may not emit light of the third color, e.g., red light. In other words, the output light LE may not include a light component having a peak wavelength in the range of about 610 nm to about 650 nm and may include only a light component having a peak wavelength in the range of about 440 nm to about 550 nm.

Referring back to FIG. 6, the first capping layer CPL1 may be disposed on the cathode CE. The first capping layer CPL1 may improve viewing angle characteristics and increase external light emission efficiency. The first capping layer CPL1 may be commonly disposed in the first light-emitting area ELA_1, the second light-emitting area ELA_2, the third light-emitting area ELA_3, and the non-light-emitting area NELA. The first capping layer CPL1 may completely cover the cathode CE.

The first capping layer CPL1 may include at least one of an inorganic material having light transmittance and an organic material. In other words, the first capping layer CPL1 may be an inorganic layer or an organic layer or may be an organic layer including inorganic particles. In some embodiments, the first capping layer CPL1 may include, but is not limited to, a triamine derivative, a carbazole biphenyl derivative, an arylenediamine derivative, or an aluminum quinolium complex (Alq3).

The thin-film encapsulation layer of the light-emitting unit 100 may be disposed on the first capping layer CPL1. The thin-film encapsulation layer may protect elements disposed under the thin-film encapsulation layer from external foreign substances such as moisture. The thin-film encapsulation layer is commonly disposed in the first light-emitting area ELA_1, the second light-emitting area ELA_2, the third light-emitting area ELA_3, and the non-light-emitting area NELA. The thin-film encapsulation layer may completely cover the first capping layer CPL1.

The thin-film encapsulation layer may include a lower inorganic layer TFEa, an organic layer TFEb, and an upper inorganic layer TFEc sequentially stacked on the first capping layer CPL1.

The lower inorganic layer TFEa may completely cover the first capping layer CPL1 in the display area DA to cover the first light-emitting element, the second light-emitting element and the third light-emitting element.

The organic layer TFEb may be disposed on the lower inorganic layer TFEa to cover the first light-emitting element, the second light-emitting element and the third light-emitting element.

The upper inorganic layer TFEc may be disposed on the organic layer TFEb to completely cover the organic layer TFEb.

In some embodiments, each of the lower inorganic layer TFEa and the upper inorganic layer TFEc may include or consist of, but not limited to, silicon nitride, aluminum nitride, zirconium nitride, titanium nitride, hafnium nitride, tantalum nitride, silicon oxide, aluminum oxide, titanium oxide, tin oxide, cerium oxide, silicon oxynitride (SiON), or lithium fluoride.

In some embodiments, the organic layer TFEb may include or consist of, but not limited to, acrylic resin, methacrylic resin, polyisoprene, vinyl resin, epoxy resin, urethane resin, cellulose resin, or perylene resin.

The light-transmitting unit 300 may have a structure in which a second substrate 310, the color filter member 320, a second capping layer CPL2, the bank layer BK, light-transmitting members, and a third capping layer CPL3 are sequentially stacked to the second side in the third direction DR3.

The light-transmitting unit 300 will now be described with reference to FIGS. 8 through 10 in addition to FIG. 6.

The light-transmitting unit 300 may have a structure in which the second substrate 310, the color filter member 320, the second capping layer CPL2, the light-transmitting members, the bank layer BK, and the third capping layer CPL3 are sequentially stacked to the second side in the third direction DR3.

The second substrate 310 of the light-transmitting unit 300 may serve as a base of the light-transmitting unit 300. The second substrate 310 may include or consist of a light-transmitting material. The second substrate 310 may be a glass substrate or a plastic substrate. When the second substrate 310 is a plastic substrate, it may have flexibility. In some embodiments, when the second substrate 310 is a plastic substrate, it may include, but is not limited to, polyimide. Since the light-emitting unit 100 and the light-transmitting unit 300 face each other in the third direction DR3 as described above, the first substrate 110 of the light-emitting unit 100 and the second substrate 310 of the light-transmitting unit 300 may face each other in the third direction DR3.

The color filter member 320 of the light-transmitting unit 300 may be disposed on a second side of the second substrate 310 in the third direction DR3, that is, between the second substrate 310 and the light-emitting unit 100. The color filter member 320 may include filtering pattern areas and a light-blocking pattern portion BM. The light-blocking pattern portion BM may surround the filtering pattern areas. The filtering pattern areas of the color filter member 320 may define light-transmitting areas of the light-transmitting unit 300, and the light-blocking pattern portion BM may define the light-blocking area BA of the light-transmitting unit 300. In an embodiment, an outer layer AF may be disposed on a first side of the second substrate 310 opposite to a second side of the second substrate 310 in the third direction DR3, but the disclosure is not limited thereto.

The color filter member 320 may include the first color filter 321, the second color filter 322, and the third color filter 323 as illustrated in FIGS. 6 and 8 through 10. The first color filter 321 may absorb both the second light and the third light except for the first light, the second color filter 322 may absorb both the first light and the third light except for the second light, and the third color filter 323 may absorb both the first light and the second light except for the third light. In other words, the first color filter 321 may transmit the first light, the second color filter 322 may transmit the second light, and the third color filter 323 may transmit the third light.

In some embodiments, the first color filter 321 may be a blue color filter and may include a blue colorant. As used herein, the term "colorant" is a concept encompassing both a dye and a pigment. The first color filter 321 may include a base resin, and the blue colorant may be dispersed in the base resin. In some embodiments, the second color filter 322 may be a green color filter and may include a green colorant. The second color filter 322 may include a base resin, and the green colorant may be dispersed in the base resin. In some embodiments, the third color filter 323 may be a red color filter and may include a red colorant. The third color filter 323 may include a base resin, and the red colorant may be dispersed in the base resin.

The first color filter 321 may include a first filtering pattern area 321a and a first light-blocking pattern area 321b surrounding the first filtering pattern area 321a. The second color filter 322 may include a second filtering pattern area 322a and a second light-blocking pattern area 322b surrounding the second filtering pattern area 322a. The third color filter 323 may include a third filtering pattern area 323a and a third light-blocking pattern area 323b surrounding the third filtering pattern area 323a. Specifically, the first filtering pattern area 321a of the first color filter 321 may overlap the first light-transmitting area TA_1, and the first light-blocking pattern area 321b of the first color filter 321 may surround the first filtering pattern area 321a overlapping the first light-transmitting area TA_1. However, the first light-blocking pattern area 321b of the first color filter 321 may not overlap the second light-transmitting area TA_2 and the third light-transmitting area TA_3 and may overlap the light-blocking area BA. The second filtering pattern area 322a of the second color filter 322 may overlap the second light-transmitting area TA_2, and the second light-blocking pattern area 322b of the second color filter 322 may surround the second filtering pattern area 322a overlapping the second light-transmitting area TA_2. However, the second light-blocking pattern area 322b of the second color filter 322 may not overlap the first light-transmitting area TA_1 and the third light-transmitting area TA_3 and may overlap the light-blocking area BA. The third filtering pattern area 323a of the third color filter 323 may overlap the third light-transmitting area TA_3, and the third light-blocking pattern area 323b of the third color filter 323 may surround the third filtering pattern area 323a overlapping the third light-transmitting area TA_3. However, the third light-blocking pattern area 323b of the third color filter 323 may not overlap the first light-transmitting area TA_1 and the second light-transmitting area TA_2 and may overlap the light-blocking area BA. In other words, the filtering pattern areas of the color filter member 320 may include the first filtering pattern area 321a of the first color filter 321, the second filtering pattern area 322a of the second color filter 322 and the third filtering pattern area 323a of the third color filter 323, and the light-blocking pattern portion BM may have a structure in which the first light-blocking pattern area 321b of the first color filter 321, the second light-blocking pattern area 322b of the second color filter 322, and the third light-blocking pattern area 323b of the third color filter 323 are stacked.

The first filtering pattern area 321a of the first color filter 321 may function as a blocking filter that blocks red light and green light. Specifically, the first filtering pattern area 321a may selectively transmit the first light (e.g., blue light) and block or absorb the second light (e.g., green light) and the third color light (e.g., red light).

The second filtering pattern area 322a of the second color filter 322 may function as a blocking filter that blocks blue light and red light. Specifically, the second filtering pattern area 322a may selectively transmit the second light (e.g., green light) and block or absorb the first light (e.g., blue light) and the third light (e.g., red light).

The third filtering pattern area 323a of the third color filter 323 may function as a blocking filter that blocks blue light and green light. Specifically, the third filtering pattern area 323a may selectively transmit the third light (e.g., red light) and block or absorb the first light (e.g., blue light) and the second light (e.g., green light).

In some embodiments, the light-blocking pattern portion BM may have a structure in which the first blocking pattern area 321b, the third light-blocking pattern area 323b, and the second light-blocking pattern area 322b are sequentially stacked in the third direction DR3. However, the disclosure is not limited thereto. In an embodiment, the light-blocking pattern portion BM may not consist of the color filters 321 through 323 described above and may include or consist of an organic light-blocking material, that is, may be formed by coating and exposing an organic light-blocking material, for example. For ease of description, a case where the light-blocking pattern portion BM has a structure in which the first light-blocking pattern area 321b, the third light-blocking pattern area 323b, and the second light-blocking pattern area 322b are sequentially stacked in the third direction DR3 will be mainly described below. The light-blocking pattern portion BM may absorb all of the first light, the second light, and the third light through the above-described configuration.

A low refractive index layer LR may be disposed on the color filter member 320. The low refractive index layer LR may have a lower refractive index than that of a first light-transmitting member TPL, a second light-transmitting member WCL1, and a third light-transmitting member WCL2 which will be described later. Therefore, the low refractive index layer LR may induce total reflection of light travelling from the first light-transmitting member TPL, the second light-transmitting member WCL1 and the third light-transmitting member WCL2 to the low refractive index layer LR, thereby recycling the light.

In some embodiments, the refractive index of the low refractive index layer LR may be 1.3 or less. When the refractive index of the low refractive index layer LR is 1.3 or less, total reflection of light may fully occur because a difference in refractive index between the first light-transmitting member TPL, the second light-transmitting member WCL1, and the third light-transmitting member WCL2 is large.

In addition, the low refractive index layer LR may play a planarization role by compensating for step differences caused by the light-blocking pattern areas 321b, 322b and 323b of the color filter member 320. Accordingly, the second capping layer CPL2 disposed on the low refractive index layer LR may be formed to be flat.

The second capping layer CPL2 of the light-transmitting unit 300 may be disposed on a surface of the low refractive index layer LR to cover the low refractive index layer LR. The second capping layer CPL2 may prevent damage to or contamination of the low refractive index layer LR and the light-blocking pattern portion BM and the filtering pattern areas of the color filter member 320 by preventing penetration of impurities such as moisture or air from the outside into the low refractive index layer LR or the color filter member 320.

The second capping layer CPL2 may include an inorganic material. The second capping layer CPL2 may be formed as a double layer as will be described later. In an embodiment, the second capping layer CPL2 may include a first layer CPL2a directly contacting the low refractive index layer LR and a second layer CPL2b disposed on the first layer CPL2a, for example. The first layer CPL2a may also be termed as a first capping layer CPL2a, and the second layer CPL2b may also be termed as a second capping layer CPL2b, especially in the claims. The first layer CPL2a and the second layer CPL2b may have different compositions. In an embodiment, a nitrogen atomic ratio of the first layer CPL2a may be smaller or greater than a nitrogen atomic ratio of the second layer CPL2b, for example. Since the second capping layer CPL2 consists of the first layer CPL2a and the second layer CPL2b having different compositions, the reliability of the light-transmitting unit 300 may be improved. This will be described in detail later.

The bank layer BK of the light-transmitting unit 300 may be disposed on a second surface of the second capping layer CPL2 in the third direction DR3 based on FIG. 6, and portions of the bank layer BK may be spaced apart from each other in the second direction DR2 to form spaces for accommodating the light-transmitting members which will be described later. That is, the bank layer BK may define the spaces in which the light-transmitting members to be described later are disposed. The bank layer BK may directly contact the second surface of the second capping layer CPL2 in the third direction DR3. The bank layer BK may surround the light-transmitting members, which will be described later, in a plan view. The bank layer BK may overlap the non-light-emitting area NELA of the light-emitting unit 100 and the light-blocking area BA of the light-transmitting unit 300. The bank layer BK may not overlap the light-emitting areas ELA_1, ELA_2 and ELA_3 of the light-emitting unit 100 and the light-transmitting areas TA_1, TA_2 and TA_3 of the light-transmitting unit 300.

In some embodiments, the bank layer BK may include, but is not limited to, a photocurable organic material or a photocurable organic material including a light-blocking material.

The light-transmitting members of the light-transmitting unit 300 may be disposed on the second surface of the second capping layer CPL2 in the third direction DR3 exposed by the spaces between the portions of the bank layer BK. The light-transmitting members may include the first light-transmitting member TPL overlapping the first light-transmitting area TA_1, the second light-transmitting member WCL1 overlapping the second light-transmitting area TA_2, and the third light-transmitting member WCL2 overlapping the third light-transmitting area TA_3. The first light-transmitting member TPL, the second light-transmitting member WCL1, and the third light-transmitting member WCL2 may be also referred to as wavelength conversion layers or wavelength conversion material layers in the claims.

The first light-transmitting member TPL may be disposed in a space defined by the bank layer BK and may overlap the first light-emitting area ELA_1 and the first light-transmitting area TA_1 in the third direction DR3. The first light-transmitting member TPL may directly contact the second capping layer CPL2 and the bank layer BK.

The first light-transmitting member TPL may be a light-transmitting pattern that transmits incident light. Specifically, the output light LE provided by the first light-emitting element may be blue light as described above and may pass through the first light-transmitting member TPL and the first filtering pattern area 321a of the first color filter 321 to exit the display device 1. In other words, first output light L1 emitted from the first light-emitting area ELA_1 to the outside through the first light-transmitting area TA_1 may be blue light.

The first light-transmitting member TPL may include a base resin 330 and light scatterers 331.

The base resin 330 may include or consist of an organic material having substantially high light transmittance. In some embodiments, the base resin 330 may include, but is not limited to, an organic material such as epoxy resin, acrylic resin, cardo resin, or imide resin.

The light scatterers 331 may have a refractive index different from that of the base resin 330 and may form an optical interface with the base resin 330. The light scatterers 331 may be light scattering particles. The light scatterers 331 may scatter incident light in random directions regardless of the incident direction of the incident light without substantially converting the wavelength of the incident light passing through the first light-transmitting area TA_1.

The light scatterers 331 may be materials that scatter at least a portion of transmitted light and may include metal oxide particles or organic particles. In some embodiments, the light scatterers 331 may include titanium oxide (TiO₂), zirconium oxide (ZrO₂), aluminum oxide (Al₂O₃), indium oxide (In₂O₃), zinc oxide (ZnO) or tin oxide (SnO₂) as the metal oxide and may include acrylic resin or urethane resin as the organic particles, but the disclosure is not limited thereto.

The second light-transmitting member WCL1 may be disposed in a space defined by the bank layer BK and may overlap the second light-emitting area ELA_2 and the second light-transmitting area TA_2 in the third direction DR3. The second light-transmitting member WCL1 may directly contact the second capping layer CPL2 and the bank layer BK.

The second light-transmitting member WCL1 may be a wavelength converting pattern that converts or shifts a peak wavelength of incident light into another predetermined peak wavelength and output light having the predetermined peak wavelength. Specifically, the output light LE provided by the second light-emitting element may be blue light as described above and may be converted into green light having a peak wavelength in the range of about 510 nm to about 550 nm as it passes through the second light-transmitting member WCL1 and the second filtering pattern area 322a of the second color filter 322. Accordingly, the green light may be emitted to the outside of the display device 1. In other words, second output light L2 emitted from the second light-emitting area ELA_2 to the outside through the second light-transmitting area TA_2 may be green light.

The second light-transmitting member WCL1 may include a base resin 330, light scatterers 331 dispersed in the base resin 330, and first wavelength shifters 332 dispersed in the base resin 330.

The first wavelength shifters 332 may convert or shift a peak wavelength of incident light to another predetermined peak wavelength. The first wavelength shifters 332 may convert the output light LE, which is blue light provided by the second light-emitting element, into green light having a single peak wavelength in the range of about 510 nm to about 550 nm and output the green light.

In some embodiments, the first wavelength shifters 332 may be, but are not limited to, quantum dots, quantum rods, or phosphors. For ease of description, a case where the first wavelength shifters 332 are quantum dots will be mainly described below. The quantum dots may be particulate materials that emit light of a predetermined color when electrons transit from a conduction band to a valence band. The quantum dots may be semiconductor nanocrystalline materials. The quantum dots may have a predetermined band gap according to their composition and size. Thus, the quantum dots may absorb light and then emit light having a unique wavelength. In embodiments, semiconductor nanocrystals of the quantum dots include group IV nanocrystals, group II-VI compound nanocrystals, group III-V compound nanocrystals, group IV-VI nanocrystals, and any combinations thereof.

The group II-VI compounds may include binary compounds including one of CdSe, CdTe, ZnS, ZnSe, ZnTe, ZnO, HgS, HgSe, HgTe, MgSe, MgS and any combinations thereof, ternary compounds including one of InZnP, AgInS, CuInS, CdSeS, CdSeTe, CdSTe, ZnSeS, ZnSeTe, ZnSTe, HgSeS, HgSeTe, HgSTe, CdZnS, CdZnSe, CdZnTe, CdHgS, CdHgSe, CdHgTe, HgZnS, HgZnSe, HgZnTe, MgZnSe, MgZnS and any combinations thereof, and quaternary compounds including one of HgZnTeS, CdZnSeS, CdZnSeTe, CdZnSTe, CdHgSeS, CdHgSeTe, CdHgSTe, HgZnSeS, HgZnSeTe, HgZnSTe and any combinations thereof.

The group III-V compounds may include binary compounds including one of GaN, GaP, GaAs, GaSb, AlN, AlP, AlAs, AlSb, InN, InP, InAs, InSb and any combinations thereof, ternary compounds including one of GaNP, GaNAs, GaNSb, GaPAs, GaPSb, AlNP, AlNAs, AlNSb, AlPAs, AlPSb, InGaP, InNP, InAIP, InNAs, InNSb, InPAs, InPSb, GaAlNP and any combinations thereof, and quaternary compounds including one of GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb and any combinations thereof.

The group IV-VI compounds may include binary compounds including one of SnS, SnSe, SnTe, PbS, PbSe, PbTe and any combinations thereof, ternary compounds including one of SnSeS, SnSeTe, SnSTe, PbSeS, PbSeTe, PbSTe, SnPbS, SnPbSe, SnPbTe and any combinations thereof, and quaternary compounds including one of SnPbSSe, SnPbSeTe, SnPbSTe and any combinations thereof. The group IV elements may be selected from silicon (Si), germanium (Ge), or any combinations thereof. The group IV compounds may be binary compounds including one of silicon carbide (SiC), silicon germanium (SiGe), and any combinations thereof.

Here, the binary, ternary or quaternary compounds may be in particles at a uniform concentration or may be in the same particles at partially different concentrations. In addition, they may have a core/shell structure in which one quantum dot surrounds another quantum dot. An interface between the core and the shell may have a concentration gradient in which the concentration of an element in the shell is reduced toward the center.

In some embodiments, the quantum dots may have a core-shell structure including a core including or consisting of the above-described nanocrystal and a shell surrounding the core. The shell of each quantum dot may serve as a protective layer for maintaining semiconductor characteristics by preventing chemical denaturation of the core and/or as a charging layer for giving electrophoretic characteristics to the quantum dot. The shell may be a single layer or a multilayer. An interface between the core and the shell may have a concentration gradient in which the concentration of an element in the shell is reduced toward the center. The shell of each quantum dot may be a metal or non-metal oxide, a semiconductor compound, or any combinations thereof, for example.

In an embodiment, the metal or non-metal oxide may be, but is not limited to, a binary compound such as SiO₂, Al₂O₃, TiO₂, ZnO, MnO, Mn₂O₃, Mn₃O₄, CuO, FeO, Fe₂O₃, Fe₃O₄, CoO, Co₃O₄ or NiO or a ternary compound such as MgAl₂O₄, CoFe₂O₄, NiFe₂O₄ or CoMn₂O₄, for example.

In addition, the semiconductor compound may be, but is not limited to, CdS, CdSe, CdTe, ZnS, ZnSe, ZnTe, ZnSeS, ZnTeS, GaAs, GaP, GaSb, HgS, HgSe, HgTe, InAs, InP, InGaP, InSb, AlAs, AlP, or AlSb.

Light emitted from the first wavelength shifters 332 may have a full width of half maximum ("FWHM") of an emission wavelength spectrum of about 45 nm or less, about 40 nm or less, or about 30 nm or less. Therefore, the color purity and color reproducibility of the display device 1 may be further improved. In addition, the light emitted from the first wavelength shifters 332 may be radiated in various directions regardless of the incident direction of incident light. Therefore, the lateral visibility of the second color displayed in the second light-transmitting area TA_2 may be improved.

A portion of the output light LE provided by the second light-emitting element may be transmitted through the second light-transmitting member WCL1 without being converted into green light by the first wavelength shifters 332. Of the output light LE, a component incident on the second filtering pattern area 322a of the second color filter 322 without being wavelength-converted by the second light-transmitting member WCL1 may be blocked by the second filtering pattern area 322a. Green light into which the output light LE has been converted by the second light-transmitting member WCL1 may be transmitted through the second filtering pattern area 322a and then emitted to the outside. That is, the second output light L2 emitted to the outside of the display device 1 through the second light-transmitting area TA_2 may be green light.

The third light-transmitting member WCL2 may be disposed in a space defined by the bank layer BK and may overlap the third light-emitting area ELA_3 and the third light-transmitting area TA_3 in the third direction DR3. The third light-transmitting member WCL2 may directly contact the second capping layer CPL2 and the bank layer BK.

The third light-transmitting member WCL2 may be a wavelength converting pattern that converts or shifts a peak wavelength of incident light into another predetermined peak wavelength and output light having the predetermined peak wavelength. Specifically, the output light LE provided by the third light-emitting element may be blue light as described above and may be converted into red light having a peak wavelength in the range of about 610 nm to about 650 nm as it passes through the third light-transmitting member WCL2 and the third filtering pattern area 323a of the third color filter 323. Accordingly, the red light may be emitted to the outside of the display device 1. In other words, third output light L3 emitted from the third light-emitting area ELA_3 to the outside through the third light-transmitting area TA_3 may be red light.

The third light-transmitting member WCL2 may include a base resin 330, light scatterers 331 dispersed in the base resin 330, and second wavelength shifters 333 dispersed in the base resin 330.

The second wavelength shifters 333 may convert or shift a peak wavelength of incident light to another predetermined peak wavelength. The second wavelength shifters 333 may convert the output light LE, which is blue light provided by the third light-emitting element, into red light having a single peak wavelength in the range of about 610 nm to about 650 nm and output the red light. In some embodiments, the second wavelength shifters 333 may be, but are not limited to, quantum dots, quantum rods, or phosphors. When the second wavelength shifters 333 are quantum dots, they may have substantially the same composition as the above-described first wavelength shifters 332 when the first wavelength shifters 332 are quantum dots, and thus a description thereof will be omitted.

A portion of the output light LE provided by the third light-emitting element may be transmitted through the third light-transmitting member WCL2 without being converted into red light by the second wavelength shifters 333. Of the output light LE, a component incident on the third filtering pattern area 323a of the third color filter 323 without being wavelength-converted by the third light-transmitting member WCL2 may be blocked by the third filtering pattern area 323a. Red light into which the output light LE has been converted by the third light-transmitting member WCL2 may be transmitted through the third filtering pattern area 323a and then emitted to the outside. That is, the third output light L3 emitted to the outside of the display device 1 through the third light-transmitting area TA_3 may be red light.

The third capping layer CPL3 of the light-transmitting unit 300 may be disposed on the bank layer BK, the first light-transmitting member TPL, the second light-transmitting member WCL1 and the third light-transmitting member WCL2 to prevent damage to or contamination of the first light-transmitting member TPL, the second light-transmitting member WCL1 and the third light-transmitting member WCL2 by preventing penetration of impurities such as moisture or air from the outside into the first light-transmitting member TPL, the second light-transmitting member WCL1 and the third light-transmitting member WCL2. The third capping layer CPL3 may cover the first light-transmitting member TPL, the second light-transmitting member WCL1, and the third light-transmitting member WCL2.

The filler 500 may be interposed between the light-emitting unit 100 and the light-transmitting unit 300 to fill the space between the light-emitting unit 100 and the light-transmitting unit 300 as described above. Specifically, in some embodiments, the filler 500 may directly contact the upper inorganic layer TFEc of the thin-film encapsulation layer of the light-emitting unit 100 and the third capping layer CPL3 of the light-transmitting unit 300. However, the disclosure is not limited thereto.

In some embodiments, the filler 500 may include or consist of a material having an extinction coefficient of substantially zero. A refractive index and an extinction coefficient are correlated, and the extinction coefficient decreases as the refractive index decreases. In addition, when the refractive index is 1.7 or less, the extinction coefficient may converge to substantially zero. In some embodiments, the filler 500 may include or consist of a material having a refractive index of about 1.7 or less. Accordingly, light provided by self-light-emitting elements may be prevented or minimized from being absorbed by the filler 500 as it passes through the filler 500. In some embodiments, the filler 500 may include or consist of an organic material having a refractive index of about 1.4 to about 1.6.

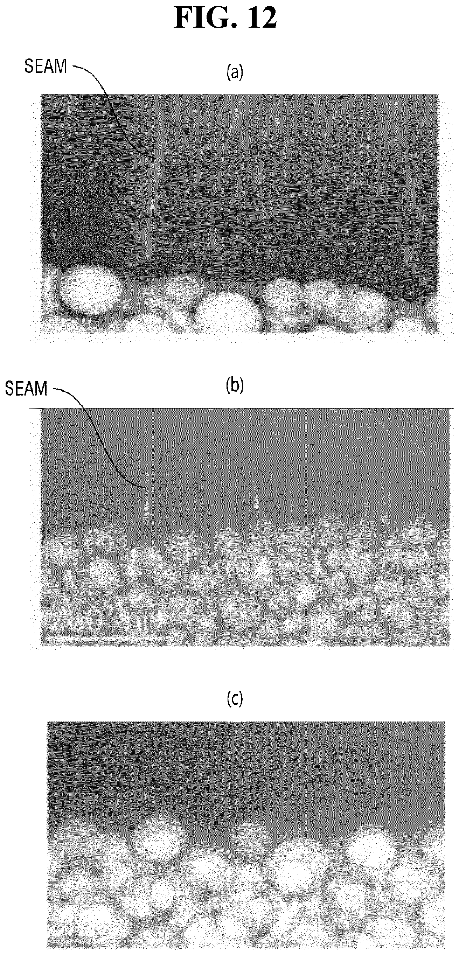

A process of forming the second capping layer CPL2 may be performed under a high-temperature condition as will be described later (refer to FIGS. 12 through 16). In this case, the second capping layer CPL2 may be damaged by outgas generated from the low refractive index layer LR or by a step formed in the low refractive index layer LR itself, and such damage may cause penetration of a developer used in a subsequent process or penetration of outside moisture, thereby reducing the reliability of the display device 1. Accordingly, it is desired to prevent the damage by forming the second capping layer CPL2 as a plurality of layers having different compositions. The structure of the second capping layer CPL2 will now be described in detail.

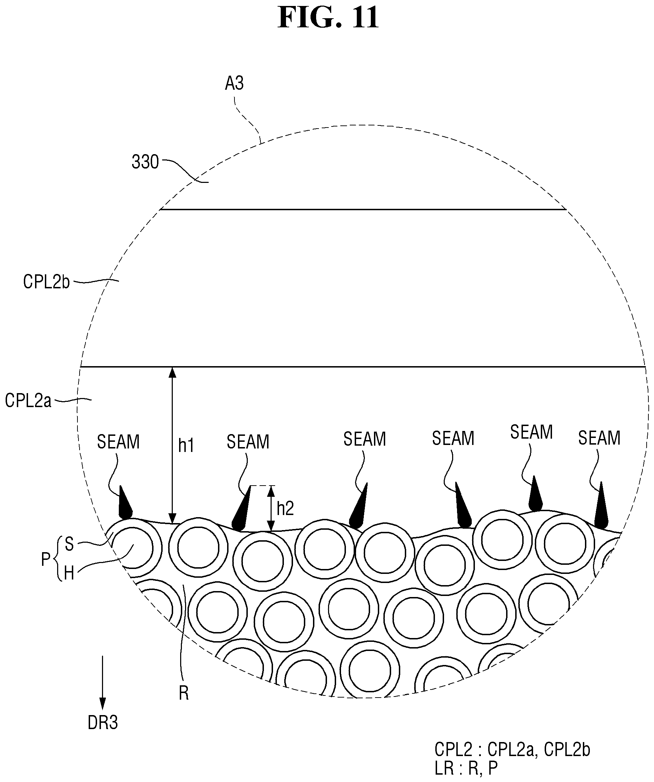

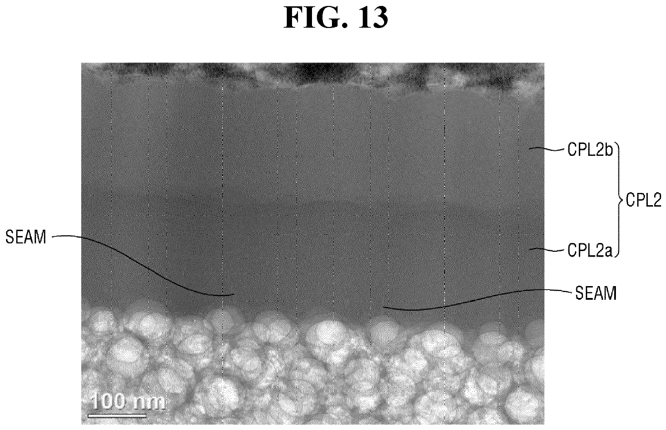

FIG. 11 is an enlarged view of area A3 of FIG. 6. FIG. 12 is a view for comparing pinholes SEAM formed in inorganic layers having different nitrogen contents. FIG. 13 is a transmission electron microscopy ("TEM") photograph of an embodiment of a second capping layer CPL2.

Referring to FIG. 11, the low refractive index layer LR may include inorganic particles P, each defining a hollow H, and a resin R. The second capping layer CPL2 may include a first layer CPL2a directly contacting the low refractive index layer LR and a second layer CPL2b disposed on the first layer CPL2a.

The inorganic particles P of the low refractive index layer LR may be dispersed in the resin R. The inorganic particles P may include one or more of silica (SiO₂), magnesium fluoride (MgF₂), and iron oxide (Fe₃O₄). Specifically, each of the inorganic particles P may include a shell S including one or more of the above materials and a hollow H defined inside the shell S and surrounded by the shell S.

The resin R may include one or more of acryl, polysiloxane, fluorinated-polysiloxane, polyurethane, fluorinated-polyurethane, polyurethane-acrylate, fluorinated-polyurethane-acrylate, a cardo binder, polyimide, polymethylsilsesquioxane ("PMSSQ"), PMMA, and a PMSSQ-PMMA hybrid.

A diameter of each inorganic particle P may be a value obtained by adding a diameter of the hollow H and a thickness of the shell S. In some embodiments, the diameter of each inorganic particle P may be about 20 nm to about 200 nm, and the thickness of the shell S may be about 5 nm to about 20 nm. Accordingly, the diameter of the hollow H may be determined. However, the disclosure is not limited thereto.

In addition, in some embodiments, a weight ratio of the inorganic particles P to the resin R may be, but is not limited to, about 1.5: 1. When the weight ratio of the inorganic particles P to the resin R is about 1.5: 1 or more, the low refractive index layer LR may have a sufficiently low refractive index of about 1.3 or less and thus efficiently induce total reflection of light. Accordingly, the low refractive index layer LR may reflect light, which passes through the second light-transmitting member WCL1 (refer to FIG. 6) and the third light-transmitting member WCL2 (refer to FIG. 6) without passing through the first wavelength shifters (also referred to as first wavelength conversion shifters) 332 (refer to FIG. 6) and the second wavelength shifters (also referred to as second wavelength conversion shifters) 333 (refer to FIG. 6) in the second light-transmitting member WCL1 and the third light-transmitting member WCL2, back to the first wavelength conversion shifters 332 and the second wavelength conversion shifters 333, thereby recycling the light.

The first layer CPL2a of the second capping layer CPL2 may be disposed on a surface of the low refractive index layer LR. The first layer CPL2a may directly contact the surface of the low refractive index layer LR. Steps due to the inorganic particles P may be formed on the surface of the low refractive index layer LR in contact with the first layer CPL2a of the second capping layer CPL2. In an embodiment, the inorganic particles P dispersed in the resin R may have a shape similar to a spherical shape, and some of the inorganic particles P may be exposed outside the resin R to form steps, for example. Accordingly, steps corresponding to the above steps may be formed on a first surface of the first layer CPL2a in direct contact with the surface of the low refractive index layer LR.

A plurality of pinholes SEAM may be formed on the first surface of the first layer CPL2a in direct contact with the surface of the low refractive index layer LR to extend from the first surface of the first layer CPL2a toward a second surface facing the first surface.

The pinholes SEAM may be formed when steps corresponding to the steps formed by the inorganic particles P of the low refractive index layer LR are, due to the steps, also formed on the first surface of the first layer CPL2a in direct contact with the surface of the low refractive index layer LR. In an alternative embodiment, the pinholes SEAM may be formed by outgas generated from the low refractive index layer LR due to a substantially high temperature accompanying the process of forming the second capping layer CPL2. A process in which the pinholes SEAM are defined will be described later.

The pinholes SEAM are tiny holes that do not completely penetrate the first layer CPL2a and may be damage that occurs during the process of forming the second capping layer CPL2. When a length h2 of each of the pinholes SEAM is greater than half of a thickness h1 of the first layer CPL2a, this may cause penetration of a developer used in a subsequent process or penetration of outside moisture, thereby reducing the reliability of the display device 1. Therefore, it is desired to improve the composition of the first layer CPL2a so that the length h2 of each of the pinholes SEAM does not exceed half of the thickness h1 of the first layer CPL2a. In some embodiments, the thickness h1 of the first layer CPL2a may be, but is not limited to, about 200 nm or more. For ease of description, a case where the thickness h1 of the first layer CPL2a is about 200 nm will be mainly described below.

Referring to FIG. 12, when a case (a) where the first layer CPL2a includes silicon oxide (SiOₓ) not including or consisting of nitrogen, a case (b) where the first layer CPL2a includes silicon oxynitride (SiOₓN_{y}) in which an atomic ratio of nitrogen is approximately 0.3%, and a case (c) where the first layer CPL2a includes silicon nitride (SiNₓ) not including or consisting of oxygen are compared, the length and number of the pinholes SEAM formed in the first layer CPL2a are the largest in the order of (a), (b), and (c). Therefore, in order to prevent penetration of a developer used in a subsequent process or penetration of outside moisture into the first layer CPL2a, the composition of the first layer CPL2a may use silicon oxynitride (SiOₓN_{y}) having a predetermined nitrogen atomic ratio or may include silicon nitride (SiNₓ) not including or consisting of oxygen.

However, silicon oxynitride (SiOₓN_{y}) generally has a correlation in which its refractive index increases as the atomic ratio of nitrogen increases. Since the refractive index of silicon nitride (SiNₓ) not including or consisting of oxygen exceeds 1.7, the silicon nitride (SiNₓ) may reduce light passing through the low refractive index layer LR, thereby reducing the luminous efficiency of the display device 1. Therefore, it is of advantage that the first layer CPL2a includes silicon oxynitride (SiOₓN_{y}) having an appropriate atomic ratio of oxygen and nitrogen in order to have a refractive index that is greater than the refractive index of the low refractive index layer LR and does not reduce the luminous efficiency of the display device 1, that is, a refractive index of about 1.4 to about 1.7.

Accordingly, the first layer CPL2a may include silicon oxynitride (SiOₓN_{y}) having a nitrogen atomic ratio of about 10% to about 35% and an oxygen atomic ratio of about 10% to about 37%. The inventors of the disclosure have found through repeated experiments that each of the pinholes SEAM formed on the first surface of the first layer CPL2a in direct contact with the surface of the low refractive index layer LR has a length h2 of about 50 nm to about 100 nm, that is, half or less of the thickness h1 of the first layer CPL2a and has a refractive index of about 1.4 to about 1.7 when the first layer CPL2a includes silicon oxynitride (SiOₓN_{y}) having a nitrogen atomic ratio of about 10% to about 35% and an oxygen atomic ratio of about 10% to about 37%. In an embodiment, as illustrated in FIG. 13, when the first layer CPL2a includes silicon oxynitride (SiOₓN_{y}) having a nitrogen atomic ratio of about 19.1%, an oxygen atomic ratio of about 36.7%, and a silicon atomic ratio of about 44.3%, each of the pinholes SEAM formed on the first surface of the first layer CPL2a in direct contact with the surface of the low refractive index layer LR may have a length h2 of about 50 nm to about 100 nm, that is, half or less of the thickness h1 of the first layer CPL2a and a refractive index of about 1.4 to about 1.7, for example.

In general, silicon oxynitride (SiOₓN_{y}) is oxidized more actively as the oxygen atomic ratio decreases. Therefore, the first layer CPL2a including silicon oxynitride (SiOₓN_{y}) in which oxygen and nitrogen are mixed may be oxidized through contact with outside moisture. Hence, in order to prevent oxidation of the first layer CPL2a, the second layer CPL2b may be formed to protect the first layer CPL2a from the outside and to include silicon oxynitride (SiOₓN_{y}) having a higher oxygen atomic ratio than that of the first layer CPL2a.

Accordingly, the second layer CPL2b may include silicon oxynitride (SiOₓN_{y}) having a nitrogen atomic ratio of about 0.2% to less than about 10% and an oxygen atomic ratio of about 40% to about 70%. The inventors of the disclosure have found through repeated experiments that oxidation of the first layer CPL2a is prevented and the pinholes SEAM are not formed in the first layer CPL2a as illustrated in FIG. 13 when the second layer CPL2b includes silicon oxynitride (SiOₓN_{y}) having a nitrogen atomic ratio of about 0.2% to less than about 10% and an oxygen atomic ratio of about 40% to about 70%. In an embodiment, as illustrated in FIG. 13, when the second layer CPL2b includes silicon oxynitride (SiOₓN_{y}) having a nitrogen atomic ratio of about 0.3%, an oxygen atomic ratio of about 64.3%, and a silicon atomic ratio of about 35.4%, oxidation of the first layer CPL2a may be prevented, and the pinholes SEAM may not be formed in the first layer CPL2a, for example.

As described above, the second capping layer CPL2 includes two layers in which the nitrogen atomic ratio of the first layer CPL2a is greater than the nitrogen atomic ratio of the second layer CPL2b, and the oxygen atomic ratio of the second layer CPL2b is greater than the oxygen atomic ratio of the first layer CPL2a. Accordingly, the second capping layer CPL2 may secure a refractive index that does not reduce the efficiency of the display device 1, may reduce the formation of the pinholes SEAM during a process, and may prevent oxidation of the first layer CPL2a, thereby ensuring the reliability of the display device 1.

The process in which the pinholes SEAM are formed during the process of manufacturing the second capping layer CPL2 will now be described.

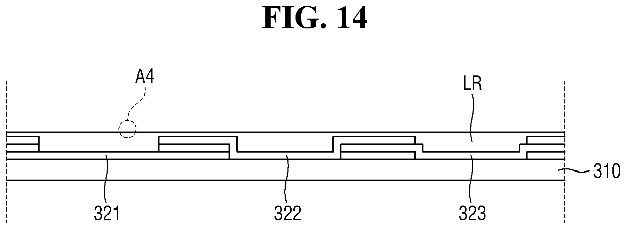

FIGS. 14 through 18 are views for explaining an embodiment of a process of manufacturing the second capping layer CPL2 of the display device 1.

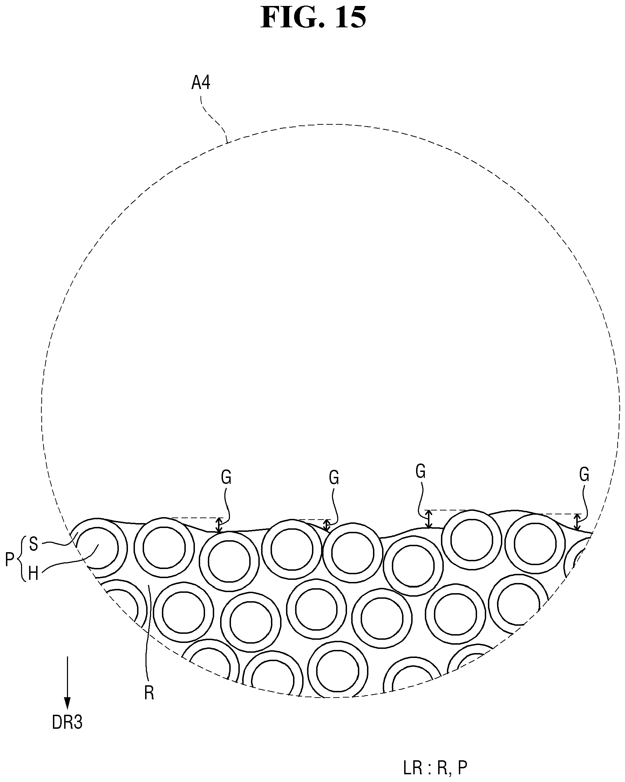

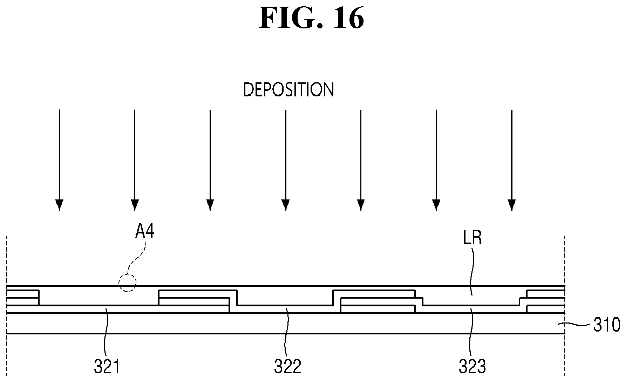

FIG. 14 illustrates the low refractive index layer LR formed on the color filter member 320. FIG. 16 illustrates a process of depositing the first layer CPL2a on the low refractive index layer LR. FIGS. 15, 17 and 18 are enlarged views of area A4 of FIG. 14 or 16. In an embodiment, area A4 may correspond to area A3 described above with reference to FIG. 6.

Referring to FIGS. 14 through 18, a method of manufacturing the second capping layer CPL2 of the display device 1 in the embodiment may include forming the color filter member 320 on the second substrate 310, forming the low refractive index layer LR on the filter member 320, and forming the first layer CPL2a of the second capping layer CPL2 on the low refractive index layer LR.

First, referring to FIGS. 14 and 15, the color filter member 320 is formed on the second substrate 310 of the display device 1 in the embodiment, and the low refractive index layer LR is formed on the color filter member 320.

In this case, since the low refractive index layer LR includes the resin R and the inorganic particles P dispersed in the resin R and having the hollows H as described above, steps G may be formed on the surface of the low refractive index layer LR due to the shape of the inorganic particles P.

Next, referring to FIGS. 16 through 18, the first layer CPL2a of the second capping layer CPL2 is formed on the low refractive index layer LR. In an embodiment, the process of forming the first layer CPL2a may be a deposition process using plasma, for example.

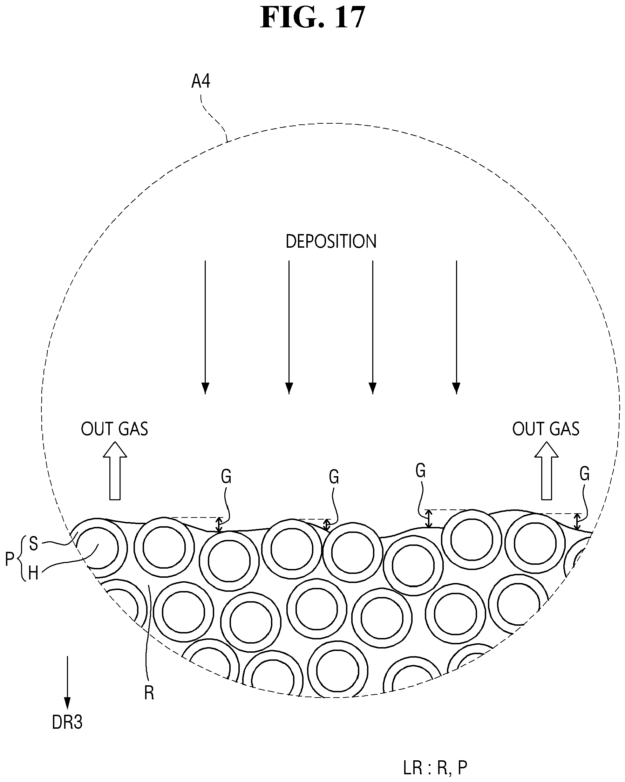

Since the process of forming the first layer CPL2a is performed under a high-temperature condition, outgas due to substantially high temperature may be emitted from the low refractive index layer LR as illustrated in FIG. 17. In addition, the first surface of the first layer CPL2a may be bent due to the steps G.

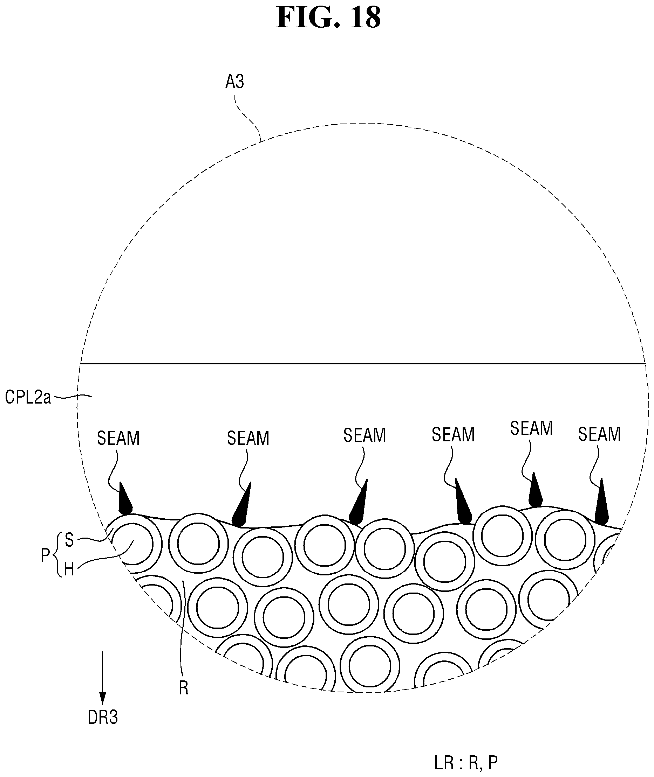

Accordingly, as illustrated in FIG. 18, a plurality of pinholes SEAM may be formed in portions where the steps G are formed due to the shape of the inorganic particle P or in portions where the outgas is emitted. Since the length of each of the pinholes SEAM does not exceed about 100 nm due to the composition of the first layer CPL2a as described above, a developer used in a subsequent process or outside moisture may not penetrate into the elements disposed under the first layer CPL2a.

Hereinafter, another embodiment of the display device 1 will be described. In the following embodiment, the same elements as those of the above-described embodiment are identified by the same reference characters, and any redundant description thereof will be omitted or given briefly, and differences will mainly be described.

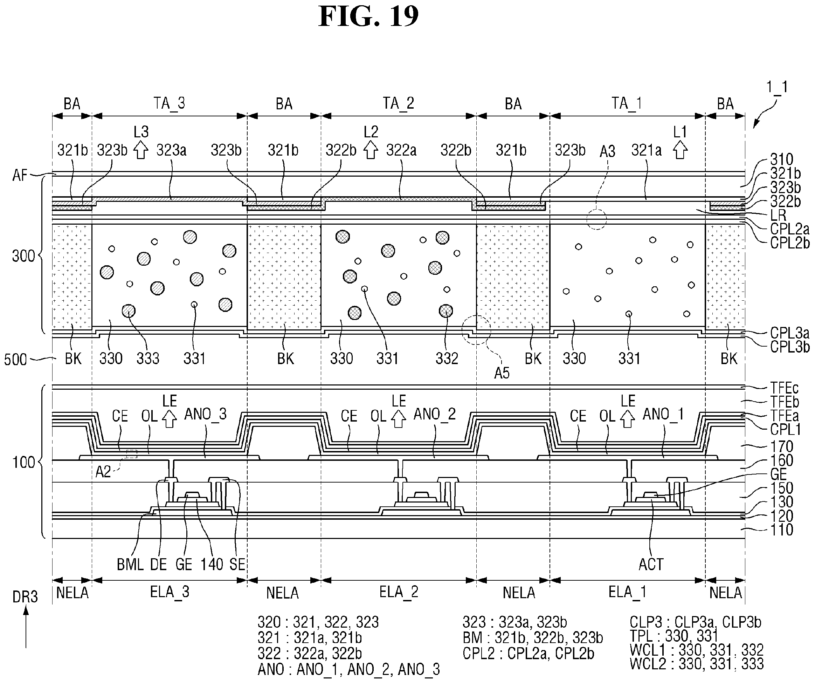

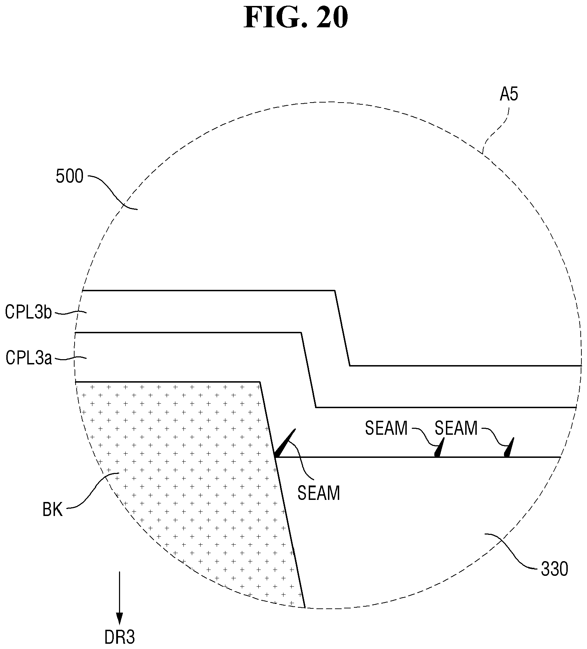

FIG. 19 is a schematic cross-sectional view of an embodiment of a pixel structure of a display device 1_1. FIG. 20 is an enlarged view of area A5 of FIG. 19.

Referring to FIGS. 19 and 20, in the display device 1_1 in the illustrated embodiment, a third capping layer CPL3 may include two layers having different element ratios. In an embodiment, the third capping layer CPL3 may include a first layer CPL3a and a second layer CPL3b, for example. The first layer CPL3a may also be termed as a first capping layer CPL3a, and the second layer CPL3b may also be termed as a second capping layer CPL3b, especially in the claims.

The first layer CPL3a of the third capping layer CPL3 may directly contact a surface of each of a first light-transmitting member TPL, a second light-transmitting member WCL1 and a third light-transmitting member WCL2 and a surface of a bank layer BK disposed between the first light-transmitting member TPL, the second light-transmitting member WCL1 and the third light-transmitting member WCL2. In an embodiment, the first layer CPL3a of the third capping layer CPL3 may directly contact a base resin 330 disposed flat in each space between portions of the bank layer BK, for example.

The bank layer BK defines the spaces in which the first light-transmitting member TPL, the second light-transmitting member WCL1 and the third light-transmitting member WCL2 are disposed, and the first light-transmitting member TPL, the second light-transmitting member WCL1 and the third light-transmitting member WCL2 do not extend beyond the spaces defined by the bank layer BK. Therefore, the surface of the bank layer BK may protrude in the third direction DR3 above the surface of each of the first light-transmitting member TPL, the second light-transmitting member WCL1 and the third light-transmitting member WCL2. In other words, as illustrated in FIG. 20, a step may be formed between the surface of the bank layer BK and the surface of each of the first light-transmitting member TPL, the second light-transmitting member WCL1 and the third light-transmitting member WCL2. Accordingly, a step corresponding to the above step may be formed on a first surface of the first layer CPL3a directly contacting the surface of each of the first light-transmitting member TPL, the second light-transmitting member WCL1 and the third light-transmitting member WCL2 and directly contacting the surface of the bank layer BK disposed between the first light-transmitting member TPL, the second light-transmitting member WCL1 and the third light-transmitting member WCL2.

Although only the arrangement relationship between the second light-transmitting member WCL1 and the bank layer BK is illustrated in FIG. 20, the arrangement relationship between the first light-transmitting member TPL and the bank layer BK and the arrangement relationship between the third light-transmitting member WCL2 and the bank layer BK are substantially the same as the arrangement relationship between the second light-transmitting member WCL1 and the bank layer BK.

A plurality of pinholes SEAM extending from the first surface of the first layer CPL3a toward a second surface opposite the first surface may be formed on the first surface of the first layer CPL3a. The pinholes SEAM may be formed by steps formed on the first surface of the first layer CPL3a or by outgas generated from the base resin 330 of each of the first light-transmitting member TPL, the second light-transmitting member WCL1 and the third light-transmitting member WCL2 due to a substantially high temperature accompanying a process of forming the third capping layer CPL3. The second layer CPL3b may be disposed directly on the second surface of the first layer CPL3a.

The first layer CPL3a of the third capping layer CPL3 in the illustrated embodiment is substantially the same as the first layer CPL2a of the second capping layer CPL2 in the previous embodiment, and the second layer CPL3b of the third capping layer CPL3 is substantially the same as the second layer CPL2b of the second capping layer CPL2 in the previous embodiment. Therefore, the composition and structure of each of the first layer CPL3a and the second layer CPL3b of the third capping layer CPL3 in the illustrated embodiment will not be described.

Similarly to the description in FIG. 11, the third capping layer CPL3 includes two layers in which a nitrogen atomic ratio of the first layer CPL3a is greater than a nitrogen atomic ratio of the second layer CPL3b, and an oxygen atomic ratio of the second layer CPL3b is greater than an oxygen atomic ratio of the first layer CPL3a. Accordingly, the third capping layer CPL3 may secure a refractive index that does not reduce the efficiency of the display device 1_1, may reduce the formation of the pinholes SEAM during a process, and may prevent oxidation of the first layer CPL3a, thereby ensuring the reliability of the display device 1_1.

A process in which the pinholes SEAM are formed during the process of manufacturing the third capping layer CPL3 will now be described.

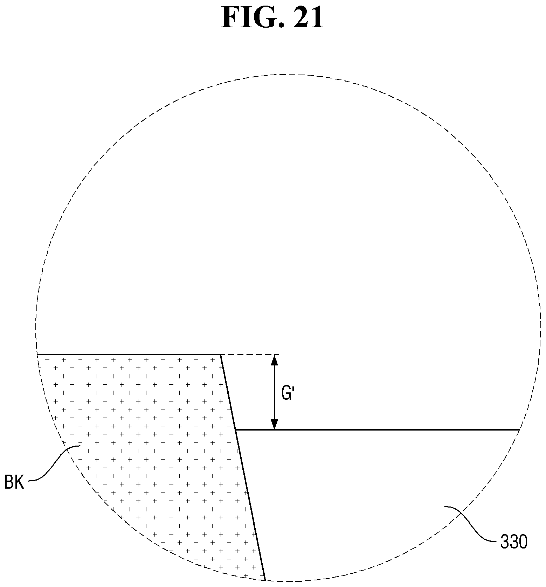

FIGS. 21 through 23 are views for explaining a process of manufacturing the third capping layer CPL3 of the display device 1_1 in the embodiment of FIG. 19.

First, referring to FIG. 21, the first light-transmitting member TPL, the second light-transmitting member WCL1, and the third light-transmitting member WCL2 are placed in the spaces between portions of the bank layer BK.

In this case, the surface of each of the first light-transmitting member TPL, the second light-transmitting member WCL1 and the third light-transmitting member WCL2 may be made flat by the base resin 330, and the first light-transmitting member TPL, the second light-transmitting member WCL1 and the third light-transmitting member WCL2 may not extend beyond the bank layer BK. Therefore, a step G' may be formed between the surface of the bank layer BK and the surface of each of the first light-transmitting member TPL, and the second light-transmitting member WCL1 and the third light-transmitting member WCL2, that is, a surface of the base resin 330.

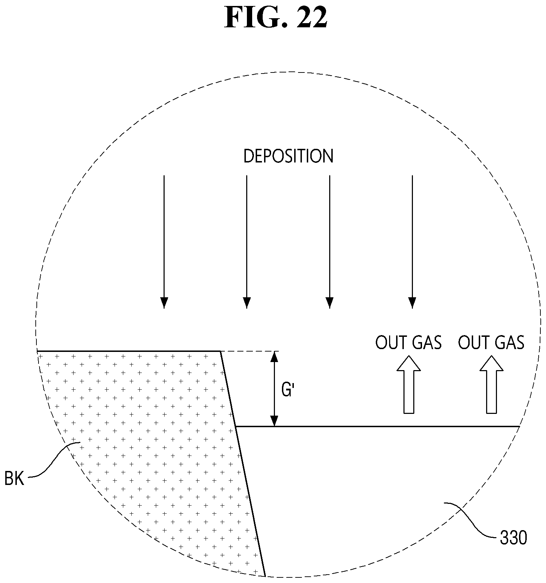

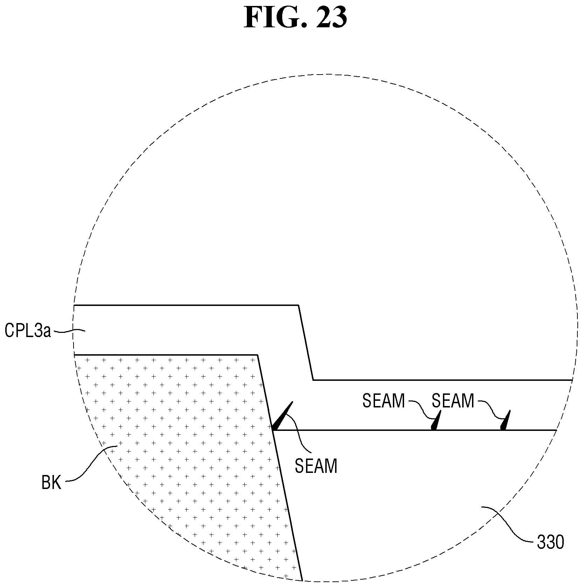

Next, referring to FIGS. 22 and 23, the first layer CPL3a of the third capping layer CPL3 is formed on the surface of each of the first light-transmitting member TPL, the second light-transmitting member WCL1, and the third light-transmitting member WCL2. In an embodiment, the process of forming the first layer CPL3a may be a deposition process using plasma, for example.

In this case, the first layer CPL3a of the third capping layer CPL3 may directly contact the base resin 330 of each of the first light-transmitting member TPL, the second light-transmitting member WCL1, and the third light-transmitting member WCL2.

Since the process of forming the first layer CPL3a is performed under a high-temperature condition, outgas due to substantially high temperature may be emitted from the base resin 330 as illustrated in FIG. 22. In addition, the first surface of the first layer CPL3a may be bent due to the step G'.

Accordingly, as illustrated in FIG. 23, a plurality of pinholes SEAM may be formed in a portion where the step G' is formed or in portions where outgas is emitted.

A display device in an embodiment may be improved in capping layer quality and panel reliability.

However, the effects of the disclosure are not restricted to the one set forth herein. The above and other effects of the disclosure will become more apparent to one of daily skill in the art to which the disclosure pertains by referencing the claims.

## Claims

1. A display device (1) comprising:
a substrate (310);
a low refractive index layer (LR) disposed on the substrate (310);
a first capping layer (CPL2a) disposed on the low refractive index layer (LR) and directly contacting an upper surface of the low refractive index layer (LR);
a second capping layer (CPL2b) disposed on the first capping layer (CPL2a); and
a wavelength conversion layer disposed on the second capping layer (CPL2b) and having a refractive index higher than a refractive index of the low refractive index layer (LR),
wherein a nitrogen atomic ratio of the first capping layer (CPL2a) is different from a nitrogen atomic ratio of the second capping layer (CPL2b).

2. A display device (1) comprising:
a first substrate (110);
a second substrate (310) facing the first substrate (110);
a light-emitting element disposed between the first substrate (110) and the second substrate (310) and emitting light;
a wavelength conversion layer disposed between the light-emitting element and the second substrate (310);
a low refractive index layer (LR) disposed between the wavelength conversion layer and the second substrate (310), comprising a resin and a plurality of inorganic particles dispersed in the resin, and having a refractive index lower than a refractive index of the wavelength conversion layer;
a first capping layer (CPL2a) disposed between the low refractive index layer (LR) and the wavelength conversion layer; and
a second capping layer (CPL2b) disposed between the first capping layer (CPL2a) and the wavelength conversion layer,
wherein an upper surface of the low refractive index layer (LR) comprises steps due to the plurality of inorganic particles, a first surface of the first capping layer (CPL2a) directly contacts the upper surface of the low refractive index layer (LR), a first surface of the second capping layer (CPL2b) directly contacts a second surface facing the first surface of the first capping layer (CPL2a), and a nitrogen atomic ratio of the first capping layer (CPL2a) is different from a nitrogen atomic ratio of the second capping layer (CPL2b).

3. The display device (1) of claim 1 or 2, wherein the first capping layer (CPL2a) comprises a plurality of pinholes (SEAM) extending from a first surface directly contacting the upper surface of the low refractive index layer (LR) toward the second surface facing the first surface, and the plurality of pinholes (SEAM) does not penetrate the first capping layer (CPL2a).

4. The display device (1) of claim 1, or of claims 1 and 3, wherein the low refractive index layer (LR) comprises a resin and a plurality of inorganic particles dispersed in the resin, and the upper surface of the low refractive index layer (LR) comprises steps due to the plurality of inorganic particles.

5. The display device (1) of claims 2 and 3, or of claim 4, wherein pinholes (SEAM) of the plurality of pinholes (SEAM) are adjacent to the steps.

6. The display device (1) of claims 1 and 4 or of claim 2, and optionally claim 3 or 5, wherein the plurality of inorganic particles comprises one or more of silica, magnesium fluoride, and iron oxide.

7. The display device (1) of claims 1 and 4 or of claim 2, and optionally at least one of claims 3, 5 or 6, wherein each of the plurality of inorganic particles has a hollow (H).

8. The display device (1) of at least one of claims 1 to 7, wherein the wavelength conversion layer comprises a bank layer (BK) defining a plurality of openings, and the bank layer (BK) comprises an organic insulating material and directly contacts a second surface facing the first surface of the second capping layer (CPL2b).

9. The display device (1) of at least one of claims 1 to 8, wherein an oxygen atomic ratio of the second capping layer (CPL2b) is greater than an oxygen atomic ratio of the first capping layer (CPL2a).

10. The display device (1) of claim 9, wherein the nitrogen atomic ratio of the first capping layer (CPL2a) is about 10 percent to about 35 percent, and the nitrogen atomic ratio of the second capping layer (CPL2b) is about 0.2 percent to about 10 percent.

11. A display device (1) comprising:
a substrate (310);
a bank layer (BK) disposed on the substrate (310) and defining a plurality of openings;
a wavelength conversion material layer disposed in the plurality of openings of the bank layer (BK);
a first capping layer (CPL3a) disposed on the bank layer (BK) and the wavelength conversion material layer; and
a second capping layer (CPL3b) disposed on the first capping layer (CPL3a),
wherein a first surface of the first capping layer (CPL3a) directly contacts an upper surface of the wavelength conversion material layer and an upper surface of the bank layer (BK), and a nitrogen atomic ratio of the first capping layer (CPL3a) is different from a nitrogen atomic ratio of the second capping layer (CPL3b).

12. The display device (1) of at least one of claims 1 to 11, wherein a first surface of the second capping layer (CPL2b, CPL3b) directly contacts a second surface of the first capping layer (CPL2a, CPL3a), and an oxygen atomic ratio of the second capping layer (CPL2b, CPL3b) is different from an oxygen atomic ratio of the first capping layer (CPL2a, CPL3a).

13. The display device (1) of at least one of claims 1 to 12, wherein the first capping layer (CPL2a, CPL3a) and the second capping layer (CPL2b, CPL3b) comprise silicon oxynitride having different element ratios.

14. The display device (1) of claim 11 and optionally one of claims 12 or 13, when dependent on claim 11, wherein the first capping layer (CPL3a) comprises a plurality of pinholes (SEAM) extending from the first surface directly contacting the upper surface of the wavelength conversion material layer and the upper surface of the bank layer (BK) toward the second surface facing the first surface, the upper surface of the bank layer (BK) and the upper surface of the wavelength conversion material layer form a step, and pinholes (SEAM) of the plurality of pinholes (SEAM) are adjacent to the step.

15. The display device (1) of claim 3 or 14 and optionally at least one of claims 4 to 10, wherein a length of each of the plurality of pinholes (SEAM) is about 50 nanometers to about 100 nanometers.
